# EUROPÄISCHE PATENTSCHRIFT

(11) **EP 4 002 683 B1**
(45) Veröffentlichungstag und Bekanntmachung des Hinweises auf die Patenterteilung: **14.02.2024**
(21) Anmeldenummer: 21208048.5
(22) Anmeldetag: 12.11.2021
(51) Int. Cl.: H02S 20/23, H01L 31/02, H02S 20/25, H02S 40/34

(54) **DACHEINDECKUNG**
ROOF COVERING
RECOUVREMENT DE TOIT

(30) Priorität: 13.11.2020 DE 102020130054
(43) Veröffentlichungstag der Anmeldung: 25.05.2022
(73) Patentinhaber: ERLUS AKTIENGESELLSCHAFT, 84088 Neufahrn (DE)
(72) Erfinder: Zielinski, Paul, 84030 Piflas (DE)
(74) Vertreter: Louis Pöhlau Lohrentz

(56) Entgegenhaltungen:
- DE-A1-102006 038 731
- DE-B3-102006 038 730
- US-A1- 2008 000 174

## Beschreibung

Die Erfindung betrifft eine Dacheindeckung für ein Dach mit Dachschräge. Die Dacheindeckung umfasst Dacheindeckelemente aus Keramikmaterial und/oder Zementmaterial, die auf einer die Dachschräge aufweisenden Dachunterkonstruktion aneinander angrenzend im Verbund angeordnet sind.

Die Dacheindeckung weist eine Photovoltaikeinrichtung auf, um mittels auf den Dacheindeckelementen aufgebrachte Solarfolie elektrischen Strom zu erzeugen. Es ist hierfür vorgesehen, dass mindestens eine Gruppe der aneinandergrenzenden Dacheindeckelemente mindestens eine Solarbaugruppe bildet, wobei die Dacheindeckelemente der Solarbaugruppe in einer oder mehreren horizontalen Reihen aneinander angrenzen und die freien Oberflächen dieser Dacheindeckelemente eine zusammengesetzte freie Oberfläche bilden, auf der ein Photovoltaik-Solarelement, das als gemeinsames Photovoltaik-Solarelement der Solarbaugruppe ausgebildet ist, mit seiner Unterseite aufliegend angeordnet ist.

Dacheindeckungen dieser Art sind bekannter Stand der Technik, z.B. aus der BE 1018016 A3. Die Solarbaugruppe in der BE 1018016 A3 besteht aus mehreren in horizontaler Reihe nebeneinander angeordneten Dacheindeckelementen, die gegenüber den Dacheindeckelementen der übrigen Dacheindeckung speziell als Trägerdacheindeckelemente zur Aufnahme des Photovoltaik-Solarelements ausgebildet sind. Die Trägerdacheindeckelemente sind gegenüber den übrigen Dacheindeckelementen der Dacheindeckung dahingehend modifiziert, dass sie einen speziellen tieferliegenden Auflagebereich aufweisen, der eine zusammengesetzte freie Oberfläche bildet, auf der das Photovoltaik-Solarelement aufliegt. Der Auflagebereich liegt in der Dacheindeckung tiefer als die freie Oberfläche der Dacheindeckelemente der übrigen Dacheindeckung. An dem linken und an dem rechten Ende der Solarbaugruppe sind Übergangsdacheindeckelemente angrenzend angeordnet, um die Höhendifferenz zu den Dacheindeckelementen der übrigen Dacheindeckung zu überbrücken.

Dacheindeckungen der eingangs genannten Art sind auch in DE 10 2006 038 730 B3, DE 10 2006 038 731 A1 und DE 10 2006 038 729 A1 beschrieben. Die Solarbaugruppe wird jeweils durch spezielle Dacheindeckelemente gebildet, d.h. durch Dacheindeckelemente, die anders ausgestaltet sind als die Dacheindeckelemente der übrigen Dacheindeckung. Diese speziellen Dacheindeckelemente erstrecken sich in der Dacheindeckung über mehrere horizontale Reihen und bilden eine zusammengesetzte ebene freie Oberfläche, auf der eine Solarfolie als gemeinsames Photovoltaik-Solarelement für die gesamte großflächige Baugruppe aufgebracht ist. Mit Abstand neben dem großflächigen Photovoltaik-Solarelement ist zum elektrischen Anschluss der Solarfolie an eine in dem Gebäude oder extern installierte elektrische Peripherieeinrichtung ein spezieller Durchgangsziegel in der Dacheindeckung angeordnet. Der Durchgangsziegel weist einen Kabeldurchgang auf, durch den ein elektrisches Anschlusskabel der Solarfolie durch die Dacheindeckung hindurchgeführt wird.

Auch in der DE 10 2006 038 731 A1 ist eine derartige Dacheindeckung beschrieben, bei der die Solarbaugruppe aus speziellen Trägerziegeln gebildet wird, die eine zusammengesetzte ebene freie Oberfläche bilden, die von dem gemeinsamen Photovoltaik-Solarelement überdeckt ist. Außerhalb dieses überdeckten Bereichs ist in der Dacheindeckung ein spezieller Durchgangsziegel angeordnet, der eine Kabeldurchführung für das Anschlusskabel aufweist. Das Anschlusskabel ist als freiliegende Schleife ausgebildet, die vom unteren Rand des Solarelements in die Kabeldurchführung des Durchgangsziegels einmündet.

Auch aus der EP 0 891 638 B1 und WO 2010/090642 A1 sind gattungsgemäße Dacheindeckungen bekannt, die Solarbaugruppen aufweisen, die aus mehreren Dacheindeckelementen bestehen, welche durch ein gemeinsames Photovoltaik-Solarelement überdeckt sind. Auch bei diesen Dacheindeckungen sind die Dacheindeckelemente der Solarbaugruppe anders ausgestaltet als die Dacheindeckelemente der übrigen Dacheindeckung.

Ferner sind Dacheindeckungen bekannt, bei denen im Unterschied zu den gattungsgemäßen Dacheindeckungen die Photovoltaikeinrichtung dadurch ausgebildet ist, dass die einzelnen Dacheindeckelemente jeweils mit einzelnen separaten Photovoltaikmodulen versehen sind. Solche Dacheindeckungen sind beschrieben z.B. in EP 2 159 850 B1, DE 28 18 474 A1, DE 42 16 171 A1 und DE 197 39 948 A1.

Eine solche Dacheindeckung mit den einzelnen Dacheindeckelementen jeweils zugeordneten separaten Photovoltaik-Solarelementen ist auch in der EP 1 071 139 B1 beschrieben. Die in dem Dacheindeckelement jeweils ausgebildete Aufnahmeausnehmung für das Anschlussaggregat weist in ihrem Boden ein Durchgangsloch zur Durchführung des Anschlusskabels auf. Zum Schutz für ein Eindringen von Wasser ist die Aufnahmeausnehmung von mehreren U-förmigen Wasserabwehrrinnen umgeben. Ein zuverlässiger Schutz gegen Eindringen von Wasser und Flugfeuer zur Dachunterkonstruktion hin ergibt sich mit diesen Maßnahmen nicht.

Die DE 10 2009 056 656 A1 beschreibt eine Dacheindeckung der eingangs genannten Art, wobei die Solarbaugruppe jedoch gebildet ist aus mehreren Dacheindeckelementen, die identisch sind wie die Dacheindeckelemente der übrigen Dacheindeckung, und einem modifizierten Dacheindeckelement, das als Anschluss-Dacheindeckelement fungiert. Die Dacheindeckelemente der gesamten Solarbaugruppe sind durch ein gemeinsames Photovoltaik-Solarmodul überdeckt. Das mitüberdeckte Anschluss-Dacheindeckelement weist als Modifikation eine Aufnahmeausnehmung zur Aufnahme eines elektrischen Anschlussaggregats auf, das an der Unterseite des Solarmodus angeordnet ist. Zur Abdichtung gegen Wassereintritt in die Aufnahmeausnehmung ist das elektrische Anschlussaggregat in die Aufnahmeausnehmung dicht eingepasst. Zusätzlich soll durch die Überdeckung durch das Solarelement eine weitere Abdichtung der Aufnahmeausnehmung erhalten werden. Ein sicherer Schutz gegen Eindringen von Wasser und Flugfeuer ist damit nicht gewährleistet.

Die US 2008/0000174 A1 beschreibt ebenfalls eine solche Dacheindeckung. Das Dokument sieht ausdrücklich vor, dass die Dacheindeckelemente der Solarbaugruppe in ihrer Formgestaltung und in ihren Abmessungen an die Dacheindeckelemente der übrigen Dacheindeckung weitgehend angepasst sind. Die Dacheindeckelemente der Solarbaugruppe sind aus leichtgewichtigem Kunststoff ausgebildet, wobei in dem Anschlussdacheindeckelement der Solarbaugruppe jeweils eine Aufnahmeausnehmung ausgebildet ist, in der die elektrische Anschlusseinrichtung des Photovoltaik-Solarelements nicht eingegossen ist, um einen Schutz gegen Eindringen von Wasser und Flugfeuer zu gewährleisten

Der Erfindung liegt die Aufgabe zugrunde, eine Dacheindeckung der eingangs genannten Art zu schaffen, die eine einfache wirtschaftliche Fertigung ermöglicht und sowohl für Neueindeckungen als auch für ein Nachrüsten von bestehenden Dacheindeckungen vorteilhaft ist und hohe Sicherheit gewährleistet.

Die Erfindung löst diese Aufgabe mit dem Gegenstand des Hauptanspruchs 1.

Bei dem Gegenstand des Hauptanspruchs 1 handelt es sich um eine Dacheindeckung für zumindest einen Abschnitt eines Daches mit Dachschräge. Die Dacheindeckung umfasst Dacheindeckelemente, die auf einer eine Dachschräge aufweisenden Dachunterkonstruktion aneinander angrenzend, vorzugsweise im Verbund angeordnet sind. Unter einer Anordnung im Verbund wird eine in der Dacheindeckung regelmäßige Anordnung der Dacheindeckelemente verstanden. Die Dacheindeckelemente können hierbei in den aneinander angrenzenden horizontalen Reihen mit einem Versatz angeordnet sein, im sog. Verband angeordnet, z.B. im Halberverband, d.h. mit einem Versatz um ein halbes Dacheindeckelement. Die Dacheindeckelemente können jedoch auch ohne Versatz angeordnet sein, in der sog. Reihenanordnung. Die Dacheindeckelemente können in entsprechender Weise auch in einer einzigen vertikalen Reihe oder in aneinander angrenzenden mehreren vertikalen Reihen angeordnet sein.

Wesentlich ist, dass mindestens eine Gruppe der aneinandergrenzenden Dacheindeckelemente mindestens eine Solarbaugruppe bildet, wobei die Dacheindeckelemente der Solarbaugruppe in einer vorgegebenen Anordnungsstruktur angeordnet sind, nämlich in einer horizontalen Reihe oder in einer vertikalen Reihe oder in mehreren aneinander angrenzenden horizontalen Reihen oder in mehreren aneinander angrenzenden vertikalen Reihen. Die Solarbaugruppe umfasst also mehrere Dacheindeckelemente, die in einer vorgegebenen Anordnungsstruktur in horizontaler Reihe aneinander angrenzend angeordnet sein können. Alternativ ist es möglich, dass die Solarbaugruppe Dacheindeckelemente umfasst, die in einer Anordnungsstruktur aus mehreren first-/traufseitig aneinandergrenzenden horizontalen Reihen aneinander angrenzen. Es ist auch möglich, dass die Solarbaugruppe Dacheindeckelemente aufweist, die in einer Anordnungsstruktur angeordnet sind, die als eine einzige vertikale Reihe oder als mehrere aneinander angrenzende vertikale Reihen ausgebildet ist. In jedem Fall bilden die freien Oberflächen der Dacheindeckelemente einer Solarbaugruppe jeweils eine zusammengesetzte freie Oberfläche, auf der ein Photovoltaik-Solarelement, das als gemeinsames Photovoltaik-Solarelement der Solarbaugruppe ausgebildet ist, mit seiner Unterseite aufliegend angeordnet ist. Die Solarbaugruppe besteht somit aus mehreren Dacheindeckelementen, d.h. aus mehr als einem Dacheindeckelement. Die Dacheindeckelemente der Solarbaugruppe sind in einer für die Solarbaugruppe vorgegebenen Anordnungsstruktur aneinander angrenzend angeordnet.

Die Lösung sieht eine Kombination der Lösungsmerkmale i), ii) und iii) vor:
Gemäß dem Lösungsmerkmal i) sind die Dacheindeckelemente der mindestens einen Solarbaugruppe (10) als Dacheindeckelemente ausgebildet, von denen mindestens eines jeweils als Anschluss-Dacheindeckelement (a) ausgebildet ist und alle übrigen jeweils als Basis-Dacheindeckelement (b) ausgebildet sind, wobei jedes der Dacheindeckelemente der Solarbaugruppe (10) eine freie Oberfläche aufweist, die gemeinsam mit den übrigen Dacheindeckelementen der Solarbaugruppe (10) die zusammengesetzte freie Oberfläche der Dacheindeckelemente der Solarbaugruppe (10) bildet, auf der das Photovoltaik-Solarelement (11) der Solarbaugruppe (10) aufliegend und sämtliche Dacheindeckelemente der Solarbaugruppe übergreifend angeordnet ist.

Die Solarbaugruppe besteht also aus mehreren Dacheindeckelementen. Es handelt sich um mindestens ein Anschluss-Dacheindeckelement und mindestens ein Basis-Dacheindeckelement, d.h. zwei verschiedene Dacheindeckelemente. Jede Solarbaugruppe besteht aus einer vorbestimmten Anzahl von Basis-Dacheindeckelementen und einer vorbestimmten Anzahl von Anschluss-Dacheindeckelementen. Es sind Ausführungen bevorzugt, die aus mehreren Basis-Dacheindeckelementen, aber nur einem Anschluss-Dacheindeckelement bestehen. Das Photovoltaik-Solarelement der Solarbaugruppe bildet ein gemeinsames Photovoltaik-Solarelement, das sämtliche Dacheindeckelemente der Solarbaugruppe übergreift und auf sämtlichen Dacheindeckelementen dieser Solarbaugruppe aufliegt. Das Photovoltaik-Solarelement ist derart bemessen und ausgestaltet, dass seine Unterseite eine der Anzahl der Dacheindeckelemente der Solarbaugruppe entsprechende zugeordnete Abschnitte aufweist, die auf der freien Oberfläche der zugeordneten Dacheindeckelemente der Solarbaugruppe aufliegend und überdeckend angeordnet sind.

Gemäß dem Lösungsmerkmal ii) sind die Dacheindeckelemente der übrigen Dacheindeckung, d.h. der nicht als Solarbaugruppe ausgebildeten Dacheindeckung als Basis-Dacheindeckelemente (b) ausgebildet, die identisch mit den Basis-Dacheindeckelementen (b) der Solarbaugruppe (10) ausgebildet sind.

Dadurch, dass die Basis-Dacheindeckelemente der Solarbaugruppe identisch ausgebildet sind wie die Dacheindeckelemente der übrigen Dacheindeckung ergeben sich wesentliche Vorteile bei der Herstellung und beim Verlegen.

Gemäß dem Lösungsmerkmal iii) ist das Anschluss-Dacheindeckelement in Formgestaltung und Abmessungen gleich ausgebildet, wie das Basis-Dacheindeckelement, jedoch mit dem Unterschied, dass in der freien Oberfläche des Anschluss-Dacheindeckelements eine Aufnahmeausnehmung zur Aufnahme einer elektrischen Anschlusseinrichtung des Photovoltaik-Solarelements - vorzugsweise zur Aufnahme eines an der Unterseite des Photovoltaik-Solarelements angeordneten elektrischen Anschlussaggregats des Photovoltaik-Solarelements - ausgebildet ist und nur die freie Oberfläche des Anschluss-Dacheindeckelements, die sich außerhalb der Aufnahmeausnehmung erstreckt, als eine freie Oberfläche des Anschluss-Dacheindeckelements ausgebildet ist, auf der ein zugeordneter Abschnitt des Photovoltaik-Solarelements aufliegend, die freie Oberfläche des Anschluss-Dacheindeckelements einschließlich die Aufnahmeausnehmung übergreifend angeordnet ist.

Erfindungsgemäß weist der Boden des Anschluss-Dacheindeckelements, welcher die Aufnahmeausnehmung für das elektrische Anschlussaggregat des Photovoltaik-Solarelements und vorzugsweise auch eine Kabelführungseinrichtung für ein Anschlusskabel des elektrischen Anschlussaggregats auf, in der Dacheindeckung in keinem der Dachunterkonstruktion zugewandten Bodenabschnitt eine Öffnung aufweist, die einen Durchtritt von Wasser und/oder Flugfeuer zur Dachunterkonstruktion hin zulässt.

Unter dem Begriff: Boden oder Bodenwandung des Dacheindeckelements wird die der Dachunterkonstruktion zugewandte oder gegenüberliegende Wand des Dacheindeckelements verstanden.

Hierfür kann vorgesehen sein, dass ausgehend von der in dem Anschluss-Dacheindeckelement ausgebildeten Aufnahmeausnehmung, die das elektrische Anschlussaggregat aufnimmt, und/oder ausgehend von der in dem Anschluss-Dacheindeckelement ausgebildeten Kabelführungseinrichtung, die das Anschlusskabel aufnimmt, eine Wasserabflusseinrichtung ausgebildet ist, die eingedrungenes Wasser aus der Aufnahmeausnehmung und/oder aus der Kabelführungseinrichtung auf die Oberseite der Dacheindeckung ableitet.

Diese Wasserableitung auf die Oberseite der Dacheindeckung kann unmittelbar oder mittelbar erfolgen. Die Wasserableitung kann derart ausgebildet sein, dass die Wasserabflusseinrichtung von der Aufnahmeausnehmung und/oder der Kabelführungseinrichtung ausgehend unmittelbar auf die Oberseite des Anschluss-Dacheindeckelements oder eines in der Dacheindeckung angrenzenden Dacheindeckelements hin führt.

Alternativ oder zusätzlich kann die Wasserableitung auch derart ausgebildet sein, dass die Wasserabflusseinrichtung ausgehend von der Aufnahmeausnehmung und/oder von der Kabelführungseinrichtung zunächst in einen Wasserfalz, z.B. einen Seitenwasserfalz des Anschluss-Dacheindeckelements oder in einen Wasserfalz eines in der Dacheindeckung angrenzenden Dacheinbauelements, z.B. in einen Kopfwasserfalz eines in der Dacheindeckung traufseitig angrenzenden Dacheindeckelements führt, um das Wasser sodann in ansich bekannter Weise auf die Oberseite der Dacheindeckung abzuleiten.

Die Aufnahmeausnehmung zur Aufnahme des elektrischen Anschlussaggregats und/oder die Kabelführungseinrichtung zur Aufnahme des Anschlusskabels kann jeweils als Aufnahme mit einem zur Dachunterkonstruktion hin geschlossenen Boden ausgebildet sein, vorzugsweise als eine Ausformung im Boden des Anschluss-Dacheindeckelements, vorzugsweise als nach oben hin offener Ausformung. Die Aufnahmeausnehmung für das elektrische Anschlussaggregat kann vorzugsweise wannenförmig ausgebildet sein.

Die Wasserabflusseinrichtung ist eine Wasserführungseinrichtung, vorzugsweise ausgeformt in dem Anschluss-Dacheindeckelement, vorzugsweise in der nach oben gewandten Oberseite des Bodens. Die Wasserabflusseinrichtung kann vorzugsweise im wesentlichen kanalförmig, z.B. als Rinne oder Nut ausgebildet sein.

Die Aufnahmeausnehmung und/oder die Kabelführungseinrichtung kann vollständig oder nur abschnittsweise durch das Photovoltaik-Solarelement und/oder durch ein in der Dacheindeckung angrenzendes Dacheindeckelement überdeckt sein.

Besonders bevorzugte Ausführungen sehen vor, dass auch der Boden des Basis-Dacheindeckelements der Solarbaugruppe und/oder Boden der Dacheindeckelemente der übrigen Dacheindeckung in keinem der Dachunterkonstruktion zugewandte Bodenabschnitt eine Öffnung aufweist, die einen Durchtritt von Wasser und/oder Flugfeuer zur Dachunterkonstruktion hin zulässt.

Es ist Gegenstand der Erfindung, dass das Anschluss-Dacheindeckelement und/oder das Basis-Dacheindeckelement einen Kopfwasserfalz und einen Fußdeckfalz aufweist und/oder einen Seitenwasserfalz und einen Seitendeckfalz aufweist. In bevorzugter Weiterbildung kann vorgesehen sein, dass in dem Anschluss-Dacheindeckelement die Aufnahmeausnehmung an dem fußseitigen Rand des Kopfwasserfalzes anschließt, vorzugsweise die Aufnahmeausnehmung und der Kopfwasserfalz ineinander übergehen, oder an dem Seitenwasserfalz anschließt, vorzugsweise die Aufnahmeausnehmung und der Seitenwasserfalz ineinander übergehen.

Bei bevorzugten Ausführungen kann vorgesehen sein, dass das auf der freien Oberfläche der Dacheindeckelemente der Solarbaugruppe aufliegende Photovoltaik-Solarelement nicht auf dem Kopfwasserfalz und/oder dem Seitenwasserfalz der Dacheindeckelemente der Solarbaugruppe aufliegend angeordnet ist und nicht den Kopfwasserfalz und/oder den Seitenwasserfalz übergreift und/oder überdeckt.

Die Aufnahmeausnehmung zur Aufnahme der elektrischen Anschlusseinrichtung, vorzugsweise des elektrischen Anschlussaggregats ist bei bevorzugten Ausführungen nach oben hin offen. Nach oben hin offen heißt, dass die Öffnung der Ausnehmung in der Ebene der freien Oberfläche des Dacheindeckelements liegt. Bei diesen Ausführungen kann aber vorgesehen sein, dass die Aufnahmeausnehmung durch das Photovoltaik-Solarelement vollständig überdeckt ist, indem das Photovoltaik-Solarelement die gesamte nach oben hin freie Öffnung der Aufnahmeausnehmung übergreift.

Alternativ sind Ausführungen möglich, bei denen die Aufnahmeausnehmung zwar ebenfalls nach oben hin offen ist, jedoch nur abschnittsweise durch das Photovoltaik-Solarelement überdeckt wird, indem das Photovoltaik-Solarelement nur abschnittsweise die nach oben hin freie Öffnung der Aufnahmeausnehmung übergreift. Der von dem Photovoltaik-Solarelement nicht überdeckte Abschnitt der Öffnung der Aufnahmeausnehmung kann durch ein in der Dacheindeckung überlappend angrenzendes Dacheinbauelement überdeckt werden, z.B. wenn die Aufnahmeausnehmung mit dem betreffenden Abschnitt in oder angrenzend einem Wasserfalzbereich, wie Kopfwasserfalzbereich und/oder Seitenwasserfalzbereich angeordnet ist.

Die Formgestaltung und Anordnung der Aufnahmeausnehmung in der freien Oberfläche des Anschluss-Dacheindeckelements ist bei bevorzugten Ausführungen so ausgestaltet, dass ein vollständiges Eintauchen der elektrischen Anschlusseinrichtung des Photovoltaik-Solarelements gewährleistet ist, wenn das Photovoltaik-Solarelement mit seiner Unterseite auf der freien Oberfläche des Anschluss-Dacheindeckelements aufliegt. Was die Formgestaltung der Aufnahmeausnehmung betrifft, kann vorteilhafterweise vorgesehen sein, dass die Aufnahmeausnehmung als eine zur freien Oberfläche des Dacheindeckelements hin offene wannenförmige Vertiefung ausgebildet ist. Was die Anordnung der Aufnahmeausnehmung in der freien Oberfläche des Anschluss-Dacheindeckelements betrifft, kann vorteilhafterweise vorgesehen sein, dass in dem Anschluss-Dacheindeckelement die Aufnahmeausnehmung in einem zwischen dem linken Seitenrand und einem rechten Seitenrand des Anschluss-Dacheindeckelements ausgebildeten Bereich der Oberseite des Anschluss-Dacheindeckelements, vorzugsweise in einem mittleren Bereich der Oberseite und/oder in einem zwischen einem kopfseitigen Rand und einem fußseitigen Rand des Anschluss-Dacheindeckelements ausgebildeten Bereichs der Oberseite des Anschluss-Dacheindeckelements, vorzugsweise einem zentralen Bereich der Oberseite des Anschluss-Dacheindeckelements ausgebildet ist.

Bei besonders bevorzugten Ausführungen ist vorgesehen, dass in dem Anschluss-Dacheindeckelements eine Kabelaufnahme zur Aufnahme eines Anschlusskabels des Photovoltaik-Solarelements ausgebildet ist, vorzugsweise als eine zur freien Oberfläche des Dacheindeckelements hin offene Aufnahmenut ausgebildet, die einen kopfseitigen Rand des Anschluss-Dacheindeckelements durchquert. In bevorzugter Weiterbildung kann vorgesehen sein, dass die Kabelaufnahme in einem kopfseitigen Abschnitt des Anschluss-Dacheindeckelements ausgebildet ist, vorzugsweise den kopfseitigen Rand des Anschluss-Dacheindeckelements durquerend. Besondere Vorteile ergeben sich, wenn vorgesehen ist, dass die Kabelaufnahme als eine vorzugsweise nach oben zur freien Oberfläche hin offene Aufnahmenut ausgebildet ist.

Die Anordnung und Ausgestaltung der Aufnahmeausnehmung ist bei bevorzugten Ausführungen derart, dass zumindest in einem Teil des Randbereichs um die Aufnahmeausnehmung eine freie Oberfläche verbleibt, die eine sichere Auflage des zugeordneten Abschnitts der Unterseite des Photovoltaik-Solarelements gewährleistet. Entsprechendes gilt bei Ausführungen, bei denen die Kabelaufnahme ebenfalls zumindest abschnittsweise in einem Bereich der freien Oberfläche des Anschluss-Dacheindeckelements ausgebildet ist und nicht nur die Aufnahmeausnehmung, sondern auch die Kabelaufnahme in diesem Bereich durch das Photovoltaik-Solarelement überdeckt werden muss. In diesem Zusammenhang sehen bevorzugte Ausführungen vor, dass zumindest ein Abschnitt der ebenen freien Oberfläche oder der periodisch profilierten freien Oberfläche des Anschluss-Dacheindeckelements in dem Anschluss-Dacheindeckelement zwischen dem linken Seitenrand und der Aufnahmeausnehmung und/oder zwischen dem rechten Seitenrand und der Aufnahmeausnehmung und/oder zwischen dem kopfseitigen Rand und der Aufnahmeausnehmung und/oder zwischen dem fußseitigen Rand und der Aufnahmeausnehmung und/oder zwischen der Kabelaufnahme (a6) und der Aufnahmeausnehmung ausgebildet ist.

Besonders bevorzugt sind auch Ausführungen, die eine Wasserabführung in dem Anschluss-Dacheindeckelement aufweisen, um eventuelles Regenwasser aus der Aufnahmeausnehmung abzuführen oder bei entsprechender Anordnung der Kabelaufnahme auch eventuelles Regenwasser aus der Kabelaufnahme abführen. Es sind in diesem Zusammenhang Ausführungen möglich, bei denen vorgesehen ist, dass in dem Anschluss-Dacheindeckelement die Aufnahmeausnehmung und/oder die Kabelaufnahme eine Wasserabführung aufweist, die Regenwasser aus der Aufnahmeausnehmung und/oder der Kabelaufnahme zum fußseitigen Rand und/oder zum linken Seitenrand und/oder zum rechten Seitenrand des Anschluss-Dacheindeckelements hin abführt.

In bevorzugter Weiterführung kann vorgesehen sein, dass die Wasserabführung aus der Aufnahmeausnehmung zum Seitenwasserfalz hin abführt und/oder auf den Fußdeckfalz hin abführt. Alternativ oder zusätzlich kann vorgesehen sein, dass die Wasserabführung aus der Kabelaufnahme zum Kopfwasserfalz hin abführt und/oder zum Seitenwasserfalz hin abführt.

Vorteilhafterweise kann bei den Ausführungen mit Wasserabführung vorgesehen sein, dass die Wasserabführung zumindest abschnittsweise als nach oben offene Rinne ausgebildet ist. Vorzugsweise kann die Wasserführung jeweils in einem Bereich angeordnet sein, der durch ein angrenzendes Dacheindeckelement überdeckt ist oder zusätzlich oder alternativ durch das Photovoltaik-Solarelement überdeckt ist.

Es ist Gegenstand der Erfindung, dass von der in dem Anschluss-Dacheindeckelement ausgebildeten Aufnahmeausnehmung eine Wasserabflusseinrichtung ausgeht, wobei die Wasserabflusseinreichung zum Fuß der Abschluss-Dacheindeckelements hin ableitet, und zwar auf die Oberseite des Fußdeckfalzes des Anschluss-Dacheindeckelements und/oder auf das in der Dacheindeckung traufseitig angeordnete Dacheindeckelement der Dacheindeckung, vorzugsweise in dem Kopfwasserfalz und/oder auf dessen freie Oberfläche und/oder auf einem auf dessen freier Oberfläche angeordnetes Photovoltaik-Solarelements, und/oder wobei die Wasserabflusseinrichtung zum Seitenrand des Anschluss-Dacheindeckelements abgeleitet, und zwar zum Seitenwasserfalz des Anschluss-Dacheindeckelements hin und/oder auf den Seitendeckfalz des Anschluss-Dacheindeckelements und von da auf ein in der Dacheindeckung seitlich benachbart angeordnetes Dacheindeckelement der Dacheindeckung, vorzugsweise in dessen Seitenwasserfalz und/oder auf dessen freie Oberfläche und/oder auf ein auf dessen freier Oberfläche angeordnete Photovoltaik-Element.

In bevorzugter Weiterbildung kann vorsehen sein, dass die Wasserabflusseinrichtung eine in dem Anschluss-Dacheindeckelements vorzugsweise ausgeformte Wasserführungseinrichtung aufweist, die als Wasserabführung ausgebildet ist, z.B. als Wasserführungsnut, Wasserführungsrinne, Wasserführungskanal. Die Wasserführungseinrichtung kann vorzugsweise in einer nach oben gewandten Oberseite des Anschluss-Dacheindeckelements, vorzugsweise nach oben offen ausgebildet sein, vorzugsweise in der nach oben gewandten Oberseite des Bodens.

Vorzugsweise kann vorgesehen sein, dass ein Übergangsbereich zwischen der Aufnahmeausnehmung und der Wasserabführung trichterförmig ausgebildet ist.

Bevorzugte Ausführungen können vorsehen, dass die Wasserabführung im Verlauf von der Aufnahmeausnehmung hin zum Ausmündungsende der Wasserführung abnehmende Tiefe aufweist.

Was das Anschlusskabel der elektrischen Anschlusseinrichtung betrifft, kann bei bevorzugten Ausführungen vorgesehen sein, dass das Anschluss-Dacheindeckelement und/oder das Photovoltaik-Solarelement eine Kabelführungseinrichtung aufweist, in der das Anschlusskabel des elektrischen Anschlussaggregats der elektrischen Anschlusseinrichtung des Photovoltaik-Solarelements zumindest abschnittsweise angeordnet ist.

Es sind bevorzugt Ausführungen vorgesehen, bei denen die Kabelführungseinrichtung wie folgt angeordnet ist,
i) dass die Kabelführungseinrichtung oder zumindest ein Abschnitt der Kabelführungseinrichtung in einem Mantel des Photovoltaik-Solarelements angeordnet ist und/oder
ii) dass die Kabelführungseinrichtung oder zumindest ein Abschnitt der Kabelführungseinrichtung im Kopfwasserfalz oder im Seitenwasserfalz des Anschluss-Dacheindeckelements angeordnet ist und/oder
iii) dass die Kabelführungseinrichtung oder zumindest ein Abschnitt der Kabelführungseinrichtung in einem kopfseitigen oder fußseitigen oder seitlich äußeren Rand des Anschluss-Dacheindeckelements vorzugsweise den Rand durchgreifend und/oder übergreifend angeordnet ist und/oder
iv) dass die Kabelführungseinrichtung oder zumindest ein Abschnitt der Kabelführungseinrichtung auf der Oberseite des Bodens des Anschluss-Dacheindeckelements in einem Bereich des Bodens außerhalb der Aufnahmeausnehmung angeordnet ist und/oder
v) dass die Kabelführungseinrichtung oder zumindest ein Abschnitt der Kabelführungseinrichtung im Boden der Aufnahmeausnehmung und/oder im oberen Randbereich der Aufnahmeausnehmung angeordnet ist.

Bei bevorzugten Ausführungen ist die Kabelführungseinrichtung nach oben hin offen. Sie kann aber vorzugsweise von dem Photovoltaik-Element überdeckt werden und/oder durch ein an dem Anschluss-Dacheindeckelement überlappend angrenzendes Dacheindeckelement überdeckt werden. Letzteres kommt vorzugsweise im Fall (ii) und/oder (iii) des Anspruchs 9 zur Anwendung, kann aber auch im Falle (i) und/oder (iv) des Anspruchs 9 vorteilhaft sein.

Bevorzugte Ausführungen können vorsehen, dass die Kabelführungseinrichtung in dem Anschluss-Dacheindeckelement ausschließlich an der nach oben gewandten Oberseite des Anschluss-Dacheindeckelements (a) ausgebildet ist, ohne dass das darin angeordnete Anschlusskabel eine Öffnung im Boden von der Oberseite zur Unterseite hin durchgreift oder umgekehrt von der Unterseite zur Oberseite hin durchgreift.

Es kann vorgesehen sein, dass die Kabelführung in dem Anschluss-Dacheindeckelement als nach oben offene bodenseitig oder randseitig angeordnete Vertiefung, vorzugsweise Nut ausgebildet ist oder als ein nach oben geschlossener und/oder umfangsseitig geschlossener bodenseitig oder randseitig angeordneter Kanal oder Durchbruch ausgebildet ist.

Es sind Ausführungen möglich, bei denen vorgesehen ist, dass die Kabelführungseinrichtung eine zugeordnete separate Wasserabflusseinrichtung aufweist oder mit der Wasserabflusseinrichtung der Aufnahmeausnehmung verbunden ist.

Es sind auch Ausführungen möglich, die vorsehen, dass die Kabelführungseinrichtung innerhalb der Wasserabflusseinrichtung der Aufnahmeausnehmung angeordnet ist.

Um sicherzustellen, dass an die Solarbaugruppe angrenzende Dacheindeckelemente kippsicher verlegt werden können, kann vorgesehen sein, dass das auf der freien Oberfläche der Dacheindeckelemente der Solarbaugruppe aufliegende Photovoltaik-Solarelement nicht auf dem Kopfwasserfalz und/oder dem Seitenwasserfalz der Dacheindeckelemente der Solarbaugruppe aufliegend angeordnet ist und nicht den Kopfwasserfalz und/oder den Seitenwasserfalz übergreift und/oder überdeckt.

Das Konzept der Erfindung sieht außerdem vor, dass das Anschluss-Dacheindeckelement und das Basis-Dacheindeckelement im Aufbau und in der Größe soweit gleich ausgebildet sind, dass sie in der Solarbaugruppe in einem einheitlichen Verbund verlegbar sind. Daraus ergibt sich in Verbindung mit der Tatsache, dass die Basis-Dacheindeckelemente der Solarbaugruppe identisch sind mit den Dacheindeckelementen der übrigen Dacheindeckung, d.h. identisch mit zumindest der Mehrzahl der Dacheindeckelemente der übrigen Dacheindeckung, dass die Dacheindeckelemente der Solarbaugruppe und die Dacheindeckelemente der übrigen Dacheindeckung in einem in der gesamten Dacheindeckung einheitlichen Verbund verlegbar sind. Durch die besondere Gestaltung des Anschluss-Dacheindeckelements mit einer Aufnahmeausnehmung in seiner freien Oberfläche, wird die Voraussetzung geschaffen, dass die an der Unterseite des Photovoltaik-Solarelements angeordnete elektrische Anschlusseinrichtung bei auf der freien Oberfläche aufliegender Solarfolie in die Aufnahmeausnehmung eintauchen kann und durch die Solarfolie abgedeckt und damit in der Dacheindeckung unsichtbar ist.

Bei besonders bevorzugten Ausführungen ist vorgesehen, dass das Anschluss-Dacheindeckelement und das Basis-Dacheindeckelement in ihrer Baugröße und/oder in ihren Abmessungen geometrisch gleich und/oder zueinander passend ausgebildet sind, dass sie in der Dacheindeckung in einem einheitlichen Verbund mit den Dacheindeckelementen der gesamten Dacheindeckung verlegbar sind. Der Vorteil dieser Ausführungen ist eine einfache Verlegung und ein optisch einheitliches Bild der Dacheindeckung.

Eine besonders gute optische Integration der Solarbaugruppe in die übrige Dacheindeckung wird mit Ausführungen erreicht, die vorsehen, dass die in horizontalen und/oder vertikalen Reihen aneinandergrenzend angeordneten Basis-Dacheindeckelemente der übrigen Dacheindeckung, d.h. der nicht als Solarbaugruppe ausgebildeten übrigen Dacheindeckung mit ihren ebenen oder periodisch profilierten freien Oberflächen eine zusammengesetzte ebene freie Oberfläche oder zusammengesetzte periodisch profilierte freie Oberfläche der horizontalen Reihe bilden, die mit der zusammengesetzten freien Oberfläche der Dacheindeckelemente der Solarbaugruppe korrespondiert und/oder übereinstimmt.

Ein wesentlicher Aspekt ist die zusammengesetzte freie Oberfläche der Dacheindeckelemente der Solarbaugruppe, da auf dieser freien Oberfläche das gemeinsame Photovoltaik-Solarelement aufliegt. Bei bevorzugten Ausführungen kann vorgesehen sein, dass die zusammengesetzte freie Oberfläche der Dacheindeckelemente der Solarbaugruppe eine geschlossene zusammengesetzte freie Oberfläche bilden, in der die freie Oberfläche der aneinander angrenzenden Dacheindeckelemente der Solarbaugruppe auf Stoß zueinander angeordnet sind oder eine unterbrochene zusammengesetzte freie Oberfläche bilden, in der die freie Oberfläche der aneinander angrenzenden Dacheindeckelemente der Solarbaugruppe mit Abstand unter Ausbildung von vorzugsweise nutenförmigen Abstandsfugen angeordnet sind. Es kann vorgesehen sein, dass das Photovoltaik-Solarelement die unterbrochene zusammengesetzte Oberfläche unter Überbrückung der Abstandsfugen übergreift.

Was die Ausgestaltung des Photovoltaik-Solarelements betrifft, kann vorzugsweise vorgesehen sein, dass das Photovoltaik-Solarelement als flache Platte oder als Folie ausgebildet ist. In bevorzugter Weiterbildung kann vorgesehen sein, dass die flache Platte als quaderförmiger, vorzugsweise starrer Körper ausgebildet ist und/oder dass die Folie als vorzugsweise flexibler Folienkörper ausgebildet ist.

Bevorzugte Ausführungen können vorsehen, dass die zusammengesetzte freie Oberfläche der Dacheindeckelemente der Solarbaugruppe, auf der das Photovoltaik-Solarelement aufliegend angeordnet ist, als ebene zusammengesetzte freie Oberfläche oder als periodisch profilierte zusammengesetzte freie Oberfläche ausgebildet ist. Mit einer ebenen zusammengesetzten freien Oberfläche ergibt sich eine besonders vorteilhafte Aufbringung des Photovoltaik-Solarelements bei gleichzeitig technischen Vorteilen hinsichtlich der Energiegewinnung und Vorteilen im optischen Gesamteindruck. Ausführungen, bei denen die zusammengesetzte freie Oberfläche periodisch profiliert ist, können in Verbindung mit der freien Oberfläche der Dacheindeckelemente der übrigen Dacheindeckung ein besonders ansprechendes optisches Aussehen ergeben und auch technisch vorteilhaft sein, z.B. hinsichtlich der Wasserführung. Unter dem Begriff "zusammengesetzte periodisch profilierte freie Oberfläche" wird verstanden, dass die durch die Dacheindeckelemente gebildete zusammengesetzte freie Oberfläche periodisch sich wiederholende Erhebungen und/oder Vertiefungen aufweist. Diese können z.B. eine wellenförmige Struktur darstellen. Die Erhebungen und/oder Vertiefungen können vorzugsweise jeweils in einer Linie First/Trauf, insbesondere ein der Falllinie verlaufen. Vorzugsweise können die Dacheindeckelemente der Solarbaugruppe jeweils eine Struktur mit einer Erhebung und/oder Vertiefung aufweisen und die aneinandergrenzenden freien Oberflächen derart miteinander korrespondieren, dass die zusammengesetzte freie Oberfläche der aneinandergrenzenden Dacheindeckelemente der Solarbaugruppe die periodisch profilierte Struktur einheitlich aufweist und diese periodisch profilierte Struktur insbesondere auch durch die zusammengesetzte freie Oberfläche der daran angrenzenden Dacheindeckelemente der übrigen Dacheindeckung fortgesetzt wird.

Bei bevorzugten Ausführungen kann vorgesehen sein, dass das Photovoltaik-Solarelement derart flexibel und/oder vorgeformt ausgebildet ist, dass das auf der zusammengesetzten freien Oberfläche der Dacheindeckelemente der Solarbaugruppe aufliegende Photovoltaik-Solarelement entsprechend der Formgestaltung der zusammengesetzten freien Oberfläche komplementär aufliegt. Dies bedeutet, dass zumindest die Unterseite des Photovoltaik-Solarelements an der Formgestaltung der zusammengesetzten freien Oberfläche der Dacheindeckelemente der Solarbaugruppe derart anpassbar oder angepasst vorgeformt ist, dass die Unterseite des Photovoltaik-Solarelements weitgehend flächig auf der zusammengesetzten freien Oberfläche aufliegen kann.

Was die Überdeckung des Basis-Dacheindeckelements durch das Photovoltaik-Solarelement betrifft:
Bei bevorzugten Ausführungen kann vorgesehen sein, dass das Photovoltaik-Solarelement mit seinen zugeordneten Abschnitten seiner Unterseite auf der freien Oberfläche des Basis-Dacheindeckelements diese übergreifend und/oder flächig darauf aufliegend angeordnet ist, und zwar auf der gesamten freien Oberfläche des Basis-Dacheindeckelements oder auf der gesamten freien Oberfläche des Basis-Dacheindeckelements mit Ausnahme eines kopfseitigen und/oder fußseitigen Randbereichs der freien Oberfläche.

Was die Überdeckung des Anschluss-Dacheindeckelements durch das Photovoltaik-Solarelement betrifft, kann entsprechend vorgesehen sein, dass das Photovoltaik-Solarelement mit seinem zugeordneten Abschnitt auf der freien Oberfläche des Anschluss-Dacheindeckelements diese übergreifend und/oder flächig darauf aufliegend angeordnet ist, und zwar auf der gesamten freien Oberfläche des Anschluss-Dacheindeckelements mit Ausnahme eines kopfseitigen und/oder fußseitigen Randbereichs der freien Oberfläche.

Vorzugsweise übergreift das Photovoltaik-Solarelement dabei die in der Oberseite des Anschluss-Dacheindeckelements ausgebildete Aufnahmeausnehmung und/oder die Kabelführungseinrichtung.

Bei diesen Ausführungen kann also zumindest der Großteil der freien Oberfläche der Dacheindeckelemente der Solarbaugruppe durch das Photovoltaik-Solarelement überdeckt sein.

Was die Befestigung des Photovoltaik-Solarelements auf der freien Oberfläche der Dacheindeckelemente der Solarbaugruppe betrifft, kann bei bevorzugten Ausführungen vorgesehen sein, dass das Photovoltaik-Solarelement, das auf der zusammengesetzten freien Oberfläche der Dacheindeckelemente der Solarbaugruppe aufliegt, auf den Dacheindeckelementen der Solarbaugruppe über eine formschlüssige mechanische Verbindung und/oder eine magnetische Verbindung und/oder eine Klebeverbindung befestigt ist.

In bevorzugter Weiterbildung kann vorgesehen sein, dass die formschlüssige Verbindung und/oder die magnetische Verbindung und/oder die Klebeverbindung einerseits im Randbereich des Photovoltaik-Solarelements und andererseits im Randbereich der zusammengesetzten freien Oberfläche der Dacheindeckelemente der Solarbaugruppe und/oder in einen daran angrenzenden Bereich, z.B. Kopfwasserfalz und/oder Seitenwasserfalz ausgebildet ist.

Bei bevorzugten Ausführungen kann vorgesehen sein, dass die formschlüssige Verbindung als eine Rastverbindung ausgebildet ist. Es kann insbesondere vorgesehen sein, dass die formschlüssige Verbindung als eine hintergreifende Verbindung ausgebildet ist, wobei in dem Dacheindeckelement der Solarbaugruppe ein hintergreifendes Verschlusselement, vorzugsweise Haken und in dem Photovoltaik-Solarelement ein Loch ausgebildet ist oder umgekehrt, dass in dem Dacheindeckelement der Solarbaugruppe ein Loch und in dem Photovoltaik-Solarelement ein hintergreifendes Verschlusselement, vorzugsweise Haken ausgebildet ist.

Alternativ oder zusätzlich kann vorgesehen sein, dass die Klebeverbindung im gesamten Bereich der flächigen Unterseite des Photovoltaik-Solarelements und im gesamten Bereich der zusammengesetzten freien Oberfläche der Dacheindeckelemente der Solarbaugruppe (10) ausgebildet ist.

Bei besonders bevorzugten Ausführungen kann vorgesehen sein,
dass die Dacheindeckelemente in der Dacheindeckung, vorzugsweise in der Dacheindeckung, die die mindestens eine Solarbaugruppe aufweist oder an die mindestens eine Solarbaugruppe angrenzt schuppenartig angeordnet, und zwar unter Ausbildung einer Art horizontaler Schuppen oder einer Art vertikaler Schuppen. Im Sinne einer Art horizontaler Schuppen kann vorgesehen sein, dass die in First-/Traufrichtung aneinander angrenzenden horizontalen Reihen der Dacheindeckelemente schuppenartig unter Ausbildung einer Art horizontaler Schuppen überlappen, vorzugsweise der traufseitige Rand und/oder Abschnitt des firstseitig angeordneten Dacheindeckelements den firstseitigen Rand und/oder Abschnitt des traufseitig angeordneten Dacheindeckelements übergreift.

Im Sinne einer Art vertikaler Schuppen kann vorgesehen sein, dass die in seitlicher Richtung aneinander angrenzenden vertikalen Reihen der Dacheindeckelemente schuppenartig unter Ausbildung einer Art vertikaler Schuppen überlappen, vorzugsweise der linksseitige Rand und/oder Abschnitt des rechtsseitig angeordneten Dacheindeckelements den rechtsseitigen Rand und/oder Abschnitt des linksseitig angeordneten Dacheindeckelements übergreift.

Bei bevorzugten Ausführungen kann vorgesehen sein, dass das Photovoltaik-Solarelement die Dacheindeckelemente der Solarbaugruppe jeweils über ihre gesamte horizontale oder vertikale Erstreckung übergreift.

Besonders bevorzugte Ausführungen sehen vor, dass das Photovoltaik-Solarelement über eines der Basis-Dacheindeckelemente der Solarbaugruppe nur über einen Teil seiner horizontalen oder vertikalen Erstreckung übergreift und über die übrigen Dacheindeckelemente der Solarbaugruppe jeweils über ihre gesamte horizontale Erstreckung übergreift.

Es kann auch vorgesehen sein, dass eines der Basis-Dacheindeckelemente der Solarbaugruppe als horizontales Teilstück eines Basis-Dacheindeckelements ausgebildet ist, welches nur einen Teil der horizontalen Erstreckung des Basis-Dacheindeckelements darstellt, und dass das Photovoltaik-Solarelement über dieses als Teilstück eines Basisdacheindeckelements ausgebildeten Basis-Dacheindeckelements der Solarbaugruppe über seine gesamte horizontale Erstreckung übergreift und auch über die übrigen Dacheindeckelemente der Solarbaugruppe jeweils über ihre gesamte horizontale Erstreckung übergreift.

Bei bevorzugten Ausführungen kann vorgesehen sein, dass die Solarbaugruppe aus in einer horizontalen Reihe oder in einer vertikalen Reihe angeordneten n Basis-Dacheindeckelementen und m Anschluss-Dacheindeckelementen ausgebildet ist, wobei n = 4 bis 10 und m = 1 bis 2 ist, wobei die n Basis-Dacheindeckelemente jeweils gleiche Baugröße aufweisen oder mindestens eines der n Basis-Dacheindeckelemente nur einen Teil der Baugröße, z.B. halbe Baugröße aufweist, z.B. als Hälfte des Basis-Dacheindeckelements ausgebildet ist, oder wobei die m Anschluss-Dachendeckelemente jeweils gleiche Baugröße aufweisen oder mindestens eines der Anschluss-Dacheindeckelemente nur einen Teil der Baugröße, z.B. halbe Baugröße aufweist, z.B. als Hälfte des Anschluss-Dacheindeckelements ausgebildet ist.

Was das Material betrifft, aus dem die Dacheindeckelemente ausgebildet sind, kann vorzugsweise vorgesehen sein,
- dass das Basis-Dacheindeckelement der Solarbaugruppe aus Keramikmaterial und/oder Zementmaterial und/oder metallischem Material ausgebildet ist, und/oder
- dass das Anschluss-Dacheindeckelement der Solarbaugruppe aus Keramikmaterial und/oder Zementmaterial und/oder metallischem Material und/oder Kunststoffmaterial ausgebildet ist, und/oder
- dass die Dacheindeckelemente der übrigen Dacheindeckung aus Keramikmaterial und/oder Zementmaterial und/oder metallischem Material ausgebildet sind, und/oder
- dass Sonderdacheindeckelemente der übrigen Dacheindeckung aus Keramikmaterial und/oder Zementmaterial und/oder metallischem Material und/oder Kunststoffmaterial ausgebildet sind.

Die Herstellung der Solarbaugruppe erfolgt vorzugsweise beim Verlegen der Dacheindeckelemente auf der Dachunterkonstruktion, d.h. beim Herstellen der Dacheindeckung. Es handelt sich um ein Verfahren zur Herstellung der Dacheindeckung, bei dem derart vorgegangen wird, dass die Herstellung der Solarbaugruppe aus einer vorgegebenen Anzahl von Basis-Dacheindeckelementen, d.h. mindestens einem Basis-Dacheindeckelement und einer vorgegebenen Anzahl von Anschluss-Dacheindeckelementen, d.h. mindestens einem Anschluss-Dacheindeckelement und einem gemeinsamen Photovoltaik-Solarelement im Zuge einer Herstellung der übrigen Dacheindeckung erfolgt, und zwar insbesondere im Zuge einer Neuverlegung der Dacheindeckung. Hierbei erfolgt die Herstellung der Solarbaugruppe,
- indem auf der Dachunterkonstruktion die Dacheindeckelemente der Solarbaugruppe, nämlich die Basis-Dacheindeckelemente und Anschluss-Dacheindeckelemente in der vorgegebenen Anzahl und in der für die Dacheindeckelemente der Solarbaugruppe vorgegebenen Anordnungsstruktur aneinander angrenzend verlegt werden und in einem vorangehenden oder nachfolgenden Schritt an die Dacheindeckelemente der Solarbaugruppe angrenzend auch die Dacheindeckelemente der übrigen Dacheindeckung auf der Dachunterkonstruktion verlegt werden, und
- indem zur Fertigstellung der Solarbaugruppe nachdem oder bevor angrenzend an die Dacheindeckelemente der Solarbaugruppe die Dacheindeckelemente der übrigen Dacheindeckung verlegt worden sind, das Photovoltaik-Solarelement auf die in der vorgegebenen Anordnungsstruktur angeordneten Dacheindeckelemente der Solarbaugruppe derart aufgebracht wird, dass die elektrische Anschlusseinrichtung des Photovoltaik-Solarelements in die Aufnahmeausnehmung des Anschluss-Dacheindeckelements eintauchend eingreift und die Unterseite des Photovoltaik-Solarelements mit ihren zugeordneten Abschnitten auf der freien Oberfläche der Dacheindeckelemente der Solarbaugruppe aufliegend angeordnet ist und dabei der dem Anschluss-Dacheindeckelement zugeordnete Abschnitt der Unterseite des Photovoltaik-Solarelements die Aufnahmeausnehmung mit der in die Aufnahmeausnehmung eintauchend angeordneten elektrischen Anschlusseinrichtung übergreift.

Die Herstellung der Solarbaugruppe kann alternativ auch im Zuge einer Nachrüstung der bereits bestehenden Dacheindeckung erfolgten. Es handelt sich hierbei um ein Verfahren zur Herstellung der Dacheindeckung, bei dem derart vorgegangen wird, dass die Herstellung der Solarbaugruppe aus einer vorgegebenen Anzahl von Basis-Dacheindeckelementen und mindestens einem Basis-Dacheindeckelement und einer vorgegebenen Anzahl von Anschluss-Dacheindeckelementen, d.h. mindestens einem Anschluss-Dacheindeckelement und einem gemeinsamen Photovoltaik-Solarelement im Zuge einer Nachrüstung der bereits bestehenden Dacheindeckung erfolgt. Hierbei erfolgt die Herstellung der Solarbaugruppe,
- indem in ein auf der Dachunterkonstruktion bestehenden Dacheindeckung mit Dacheindeckelementen - angeordnet in einer für die Dacheindeckelemente der Solarbaugruppe vorgegebenen Anordnungsstruktur - mindestens ein Basis-Dacheindeckelement in dieser Anordnungsstruktur ersetzt wird durch mindestens ein Anschluss-Dacheindeckelement derart, dass in der bestehenden Dacheindeckung eine Anordnungsstruktur mit Dacheindeckelementen der Solarbaugruppe gebildet wird; und
- indem zur Fertigstellung der Solarbaugruppe das Photovoltaik-Solarelement auf die Dacheindeckelemente in der Anordnungsstruktur der Solarbaugruppe derart aufgebracht wird, dass die elektrische Anschlusseinrichtung des Photovoltaik-Solarelements in die Aufnahmeausnehmung des Anschluss-Dacheindeckelements eintauchend eingreift und die Unterseite des Photovoltaik-Solarelements mit ihren zugeordneten Abschnitten auf der freien Oberfläche der Dacheindeckelemente der Solarbaugruppe aufliegend angeordnet ist und dabei der dem Anschluss-Dacheindeckelement zugeordnete Abschnitt der Unterseite des Photovoltaik-Solarelements die Aufnahmeausnehmung mit der in die Aufnahmeausnehmung eintauchend angeordneten elektrischen Anschlusseinrichtung übergreift.

In der nachfolgenden Beschreibung wird die Erfindung unter Bezugnahme auf Figuren beschrieben.

Dabei zeigen:
- Fig. 1:: ein erstes Ausführungsbeispiel einer Dacheindeckung aus Dacheindeckelementen auf einer Dachunterkonstruktion mit zwei Solarbaugruppen, in Draufsicht von oben;
- Fig. 2:: eine Fig. 1 entsprechende Darstellung eines zweiten Ausführungsbeispiels einer Dacheindeckung mit zwei Solarbaugruppen, die jedoch im Unterschied zu Fig. 1 zueinander versetzt sind;
- Fig. 3:: eine der beiden Solarbaugruppen in Fig. 1 mit nur teilweise Überdeckung des endständigen Basis-Dacheindeckelements der Solarbaugruppe, in Draufsicht von oben;
- Fig. 4:: eine der beiden Solarbaugruppen in Fig. 2 mit halbem Basis-Dacheindeckelement als endständiges Basis-Dacheindeckelement der Solarbaugruppe, in Draufsicht von oben;
- Fig. 5:: eine gegenüber Fig. 3 und Fig. 4 abgewandelte Ausführung der Solarbaugruppen, hier mit vollständiger Überdeckung des endständigen Basis-Dacheindeckelements der Solarbaugruppe, in Draufsicht von oben;
- Fig. 6:: einen vergrößerten Ausschnitt im Bereich X1 in Fig. 3;
- Fig. 7:: einen vergrößerten Ausschnitt im Bereich X2 in Fig. 3;
- Fig. 8a:: ein Basis-Dacheindeckelement der Solarbaugruppe in Fig. 2, in Draufsicht von oben;
- Fig. 8b:: das Basis-Dacheindeckelement in Fig. 8a, in Draufsicht von unten;
- Fig. 9a:: ein Anschluss-Dacheindeckelement der Solarbaugruppe in Fig. 2, in Draufsicht von oben;
- Fig. 9b:: das Anschluss-Dacheindeckelement in Fig. 9a, in Draufsicht von unten,
- Fig. 10:: ein Anschluss-Dacheindeckelement der Solarbaugruppe gemäß einem weiteren Ausführungsbeispiel, in Draufsicht von oben
- Fig. 11:: ein Anschluss-Dacheindeckelement der Solarbaugruppe gem. einem noch weiteren Ausführungsbeispiel, in Draufsicht von oben;
- Fig. 12:: eine Fig. 1 entsprechende Darstellung eines weiteren Ausführungsbeispiels einer Dacheindeckung, wobei jedoch die Solarbaugruppen in vertikalen Reihen angeordnet sind;
- Fig. 13:: ein Basis-Dacheindeckelement der Solarbaugruppe in Fig. 12, in Draufsicht von oben;
- Fig. 14:: das Basis-Dacheindeckelement aus Fig. 13, in Draufsicht von unten;
- Fig. 15:: das Basis-Dacheindeckelement aus Fig. 13, in Seitenansicht perspektivisch;
- Fig. 16:: eine vergrößerte Darstellung im Bereich X in Fig. 12, das Anschluss-Dacheindeckelement und das Basis-Dacheindeckelementen der Solarbaugruppe zeigend, in Draufsicht von oben.

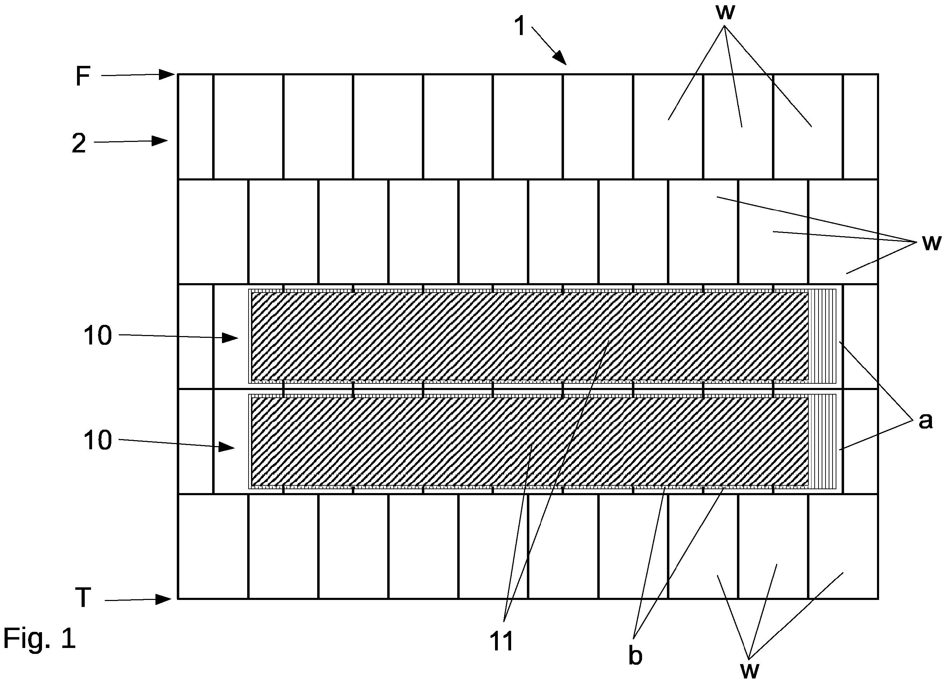

Die Dacheindeckung in Fig. 1 stellt ein Ausführungsbeispiel einer erfindungsgemäßen Dacheindeckung 1 dar. Sie besteht aus einer Mehrzahl von Dacheindeckelementen a, b, w, die auf einer Dachunterkonstruktion 2 im Halberverband angeordnet sind. Die Dachunterkonstruktion 2 weist horizontale Dachlatten 2h auf, die über Dachsparren 2s verbunden sind. Die sich in der Linie First F - Trauf T erstreckenden Dachsparren 2s bilden bei dem dargestellten Ausführungsbeispiel eine Dachschräge mit konstantem Neigungswinkel.

Die Dacheindeckelemente a, b, w in der Dacheindeckung 1 in Fig. 1 sind in horizontalen Reihen derart angeordnet, dass die jeweils firstseitig horizontalen Reihen die traufseitig angrenzenden horizontalen Reihen schuppenartig überlappen.

### Die Solarbaugruppen

Wesentlich ist, dass zumindest ein Teil der Dacheindeckelemente in Solarbaugruppen 10 vorliegen. Bei dem in Fig. 1 dargestellten Ausführungsbeispiel der Dacheindeckung sind in dem dargestellten Abschnitt der Dacheindeckung zwei Solarbaugruppen verlegt. Die beiden Solarbaugruppen 10 sind in zwei aneinander grenzenden horizontalen Reihen angeordnet. Sie sind seitlich, d.h. auf ihrer linken Endseite und ihrer rechten Endseite miteinander fluchtend angeordnet. Die zwei Solarbaugruppen 10 bestehen im dargestellten Fall jeweils aus 8 Basis-Dacheindeckelementen b und einem Anschluss-Dacheindeckelement a. Die Dacheindeckelemente jeder Solarbaugruppe sind jeweils in einer horizontalen Reihe nebeneinander angrenzend angeordnet. Die Dacheindeckelemente a, b jeder Solarbaugruppe 10 sind durch ein gemeinsames Photovoltaik-Solarelement 11 überdeckt. D.h. jede Solarbaugruppe 10 hat ein gemeinsames Photovoltaik-Solarelement 11, das auf den Dacheindeckelementen b, a der Solarbaugruppe aufliegt. Das Photovoltaik-Solarelement 11 ist jeweils so ausgebildet, dass es das Anschluss-Dacheindeckelement a und die angrenzenden sieben Basis-Dacheindeckelemente b und das endständige Basis-Dacheindeckelement b überdeckt, wobei das endständige Basis-Dacheindeckelement b lediglich über seine halbe horizontale Erstreckung überdeckt wird.

Bei den Dacheindeckelementen der Solarbaugruppe 10 handelt es sich also um 7,5 Basis-Dacheindeckelemente b und einem Anschluss-Dacheindeckelement a. Die weiteren Dacheindeckelemente der Dacheindeckung 1, die nicht Dacheindeckelemente einer Solarbaugruppe 10 sind, sind in der Fig. 1 mit dem Bezugszeichen w bezeichnet. Diese Dacheindeckelemente w sind bei dem dargestellten Ausführungsbeispiel identisch ausgebildet wie die Basis-Dacheindeckelemente b der Solarbaugruppe 10.

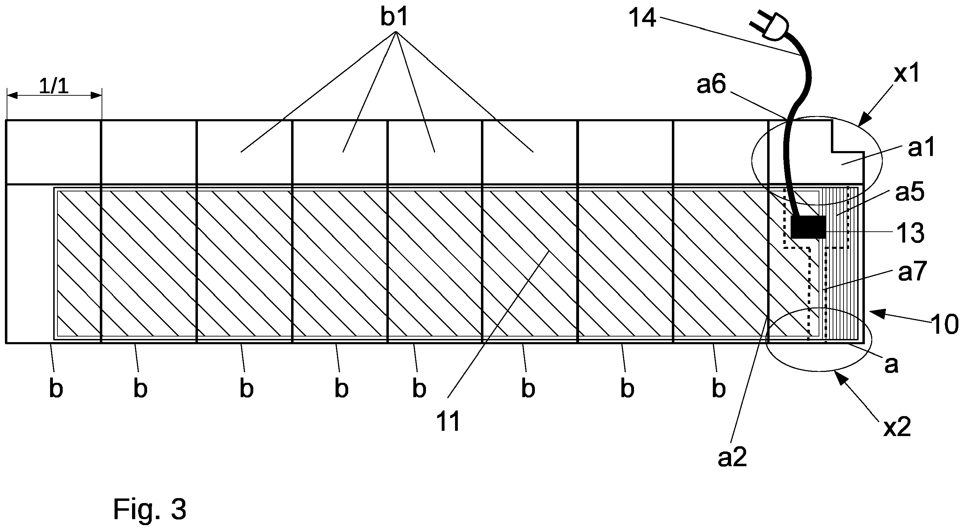

Das Photovoltaik-Solarelement 11 ist in dem dargestellten Ausführungsbeispiel eine flexible Folie. In Fig. 3 ist eine Draufsicht der Solarbaugruppe in Fig. 1 Darstellung gezeigt. In dieser Darstellung ist die Überdeckung der Dacheindeckelemente a, b der Solarbaugruppe 10 durch das Photovoltaik-Solarelement 11 erkennbar, indem die verdeckten Kanten gestrichelt dargestellt sind. Das Photovoltaik-Solarelement 11, als in Draufsicht rechteckiger Streifen, überdeckt die zusammengesetzte freie Oberfläche, die durch die Dacheindeckelemente a, b der Solarbaugruppe 10 gebildet wird, mit Ausnahme des kopfseitigen Wasserfalzbereichs der Dacheindeckelemente. Das endständige Basis-Dacheindeckelement b ist nur über seine halbe horizontale Erstreckung durch das Photovoltaik-Solarelement 11 überdeckt.

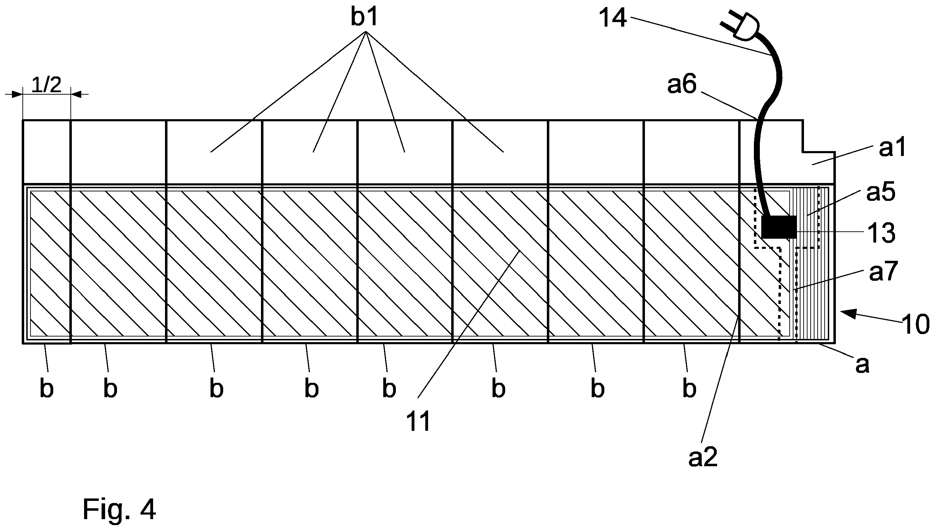

Wie in Fig. 4 dargestellt, kann bei einer alternativen Ausführung die Solarbaugruppe 10 auch dahingehend abgewandelt ausgebildet sein, dass die Dacheindeckelemente der Solarbaugruppe aus einem Anschluss-Dacheindeckelement a und sieben ganzen Basis-Dacheindeckelementen b und einem halben Basis-Dacheindeckelement b gebildet ist.

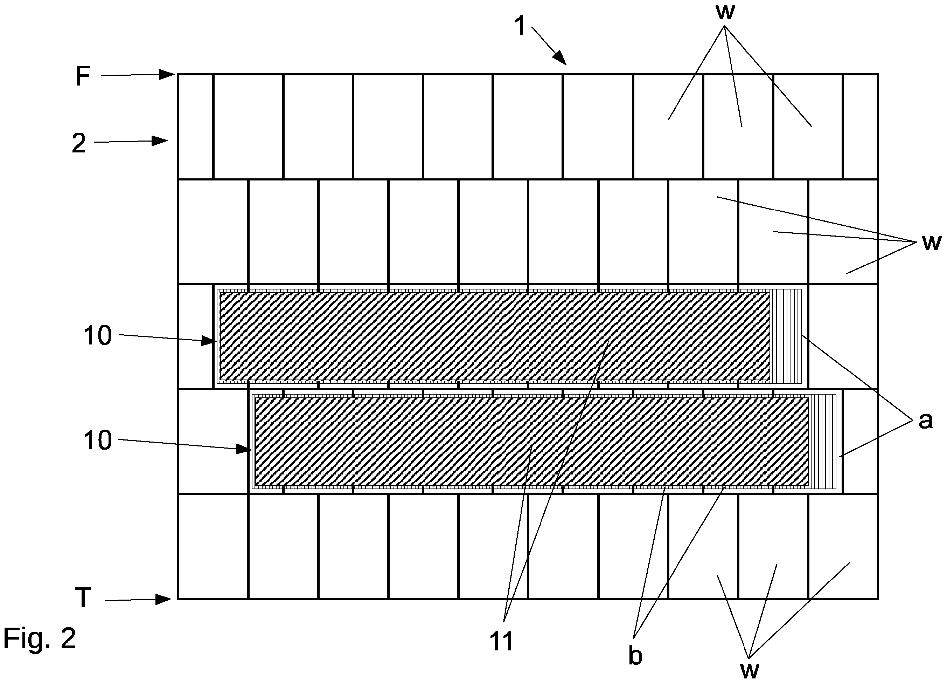

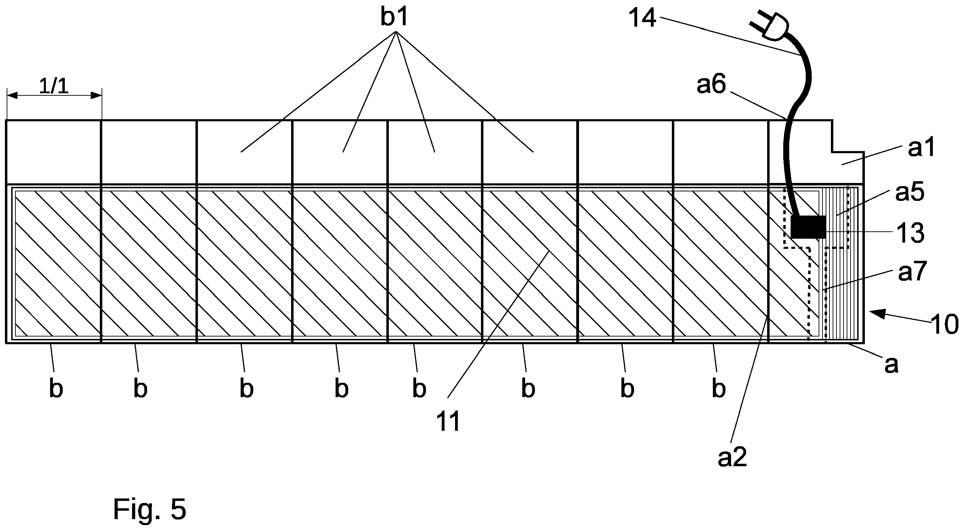

Ein weiter abgewandeltes Ausführungsbeispiel kann darin bestehen, dass die Solarbaugruppe 10, wie in Fig. 5 dargestellt aus acht ganzen Basis-Dacheindeckelementen b und einem Anschluss-Dacheindeckelement a besteht. Das gemeinsame Photovoltaik-Solarelement 11 überdeckt die in einer horizontalen Reihe angeordneten Dacheindeckelemente der Solarbaugruppe, d.h. neun Dacheindeckelemente, jeweils über ihre gesamte horizontale Erstreckung. In Fig. 2 ist eine Dacheindeckung gezeigt, bei der zwei Solarbaugruppen 10 ebenfalls in zwei aneinander angrenzenden horizontalen Reihen angeordnet sind. Die Solarbaugruppen 10 sind jedoch im Unterschied zu dem Ausführungsbeispiel in Fig. 1 seitlich zueinander versetzt, so dass sie seitlich nicht fluchtend miteinander abschließen. Sie sind, wie in Fig. 4 erkennbar, aus einem Anschluss-Dacheindeckelement a und sieben Basis-Dacheindeckelementen b und einem endständigen halben Basis-Dacheindeckelement b ausgebildet. Das Photovoltaik-Solarelement 11 überdeckt diese Dacheindeckelemente a, b der Solarbaugruppe über ihre gesamte horizontale Erstreckung.

### Die Überdeckung und Befestigungseinrichtung des Photovoltaik-Solarelements auf der freien Oberfläche der Dacheindeckelemente der Solarbaugruppe

Das Photovoltaik-Solarelement 11 liegt auf den Dacheindeckelementen a, b der Solarbaugruppe 10 auf den ebenen freien Oberflächenabschnitten der Dacheindeckelemente a, b auf, vorzugsweise über eine Klebeverbindung auf den Auflageflächen fixiert. Zusätzlich ist das Photovoltaik-Solarelement 11 über mechanische Befestigungselemente a15, b15 mit den Dacheindeckelementen a, b der Solarbaugruppe 10 verbunden. Hierfür ist auf jedem Basis-Dacheindeckelement b ein Befestigungselement b15 und auf jedem Anschluss-Dacheindeckelement a ein Befestigungselement a15 angeordnet. Die Befestigungselemente b15, a15 wirken formschlüssig mit an dem Photovoltaik-Solarelement 11 angeordneten Befestigungselementen 15 zusammen, z.B. im Sinne einer Verhakung oder Verrastung. Hierfür sind an dem firstseitigen Rand des Photovoltaik-Solarelements 11 neun Befestigungselemente 15 angeordnet, Jedes der Befestigungselemente 15 wirkt mit einem Photovoltaik-Solarelement der Dacheindeckelemente der Solarbaugruppe zusammen, d.h. acht Befestigungselemente 15 wirken mit den Befestigungselementen b15 auf den Basis-Dacheindeckelementen b und ein Befestigungselement 15 wirkt mit einem Befestigungselement a15 auf dem Anschluss-Dacheindeckelement a zusammen.

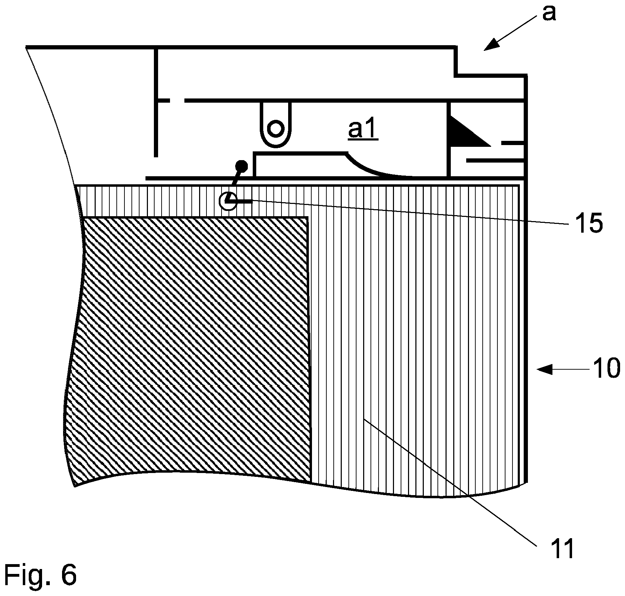

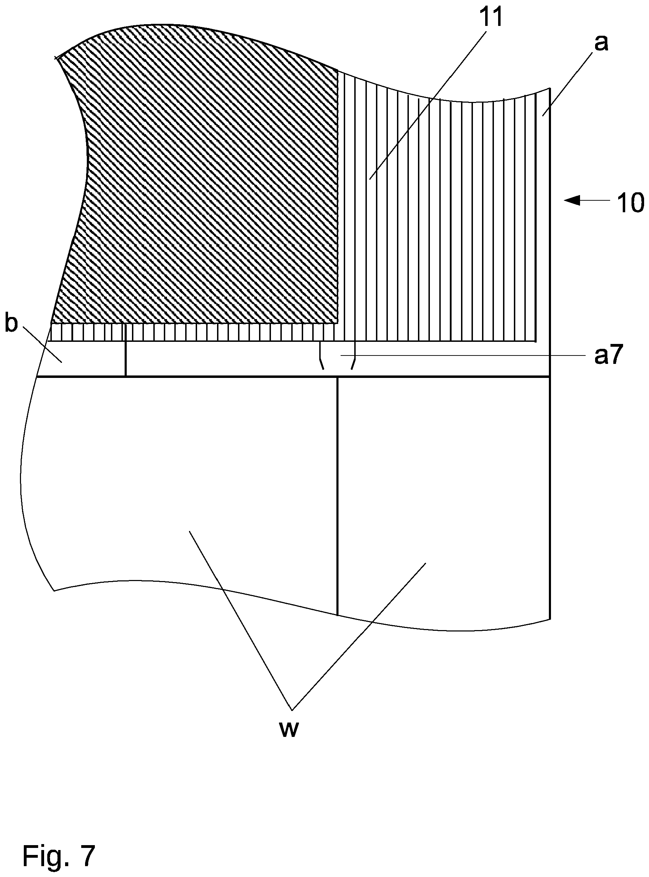

Die Figuren 6 und 7 zeigen die Randbereiche des Photovoltaik-Solarelements 11 in vergrößerter Einzeldarstellung. In Fig. 6 ist erkennbar, dass das Photovoltaik-Solarelement 11 über Haken-Loch-Verbindungen mit den Dacheindeckelementen der Solarbaugruppe verbunden ist. Es handelt sich um insgesamt neun solcher Haken-Loch-Verbindungen. Jedes Dacheindeckelement der Solarbaugruppe weist jeweils eine Haken-Loch-Verbindung zur Verbindung mit dem Photovoltaik-Solarelement 11 auf. Die Haken-Loch-Verbindung besteht aus einem Haken, der in der Oberseite des Dacheindeckelements a, b nach oben abstehend angeordnet ist. Es kann sich um einen Schraubhaken handeln. Der Haken ist im Kopfwasserfalzbereich a1, b1 positioniert, und zwar im Bereich des traufseitigen Rands des Kopfwasserfalzes. Das jeweils zugeordnete Loch im firstseitigen Randbereich des Photovoltaik-Solarelements 11 ist so positioniert, dass im eingehängten Zustand der firstseitige Rand des Photovoltaik-Solarelements 11 unmittelbar im Randbereich des Kopfwasserfalzes a1, b1 des betreffenden Dacheindeckelements a, b liegt. Die Haken-Loch-Verbindung kann zusätzlich oder alternativ zu einer Klebebefestigung des Photovoltaik-Solarelements 11 auf der freien Oberfläche der Dacheindeckelemente a, b der Solarbaugruppe vorgesehen sein.

Aus der Darstellung in Fig. 7 ist zu ersehen, dass das Photovoltaik-Solarelement 11, das die zusammengesetzte freie Oberfläche der die Solarbaugruppe 10 bildenden Dacheindeckelemente a, b über ihre horizontale Erstreckung übergreift mit seinem traufseitigen Rand fast bis zu dem traufseitigen Rand der überdeckten Dacheindeckelemente der Solarbaugruppe reicht, und zwar derart, dass der traufseitige Rand der überdeckten Dacheindeckelemente frei bleibt und in Fig. 7 erkennbar die Wasserabflussrinne b7 bzw. a7 im Bereich ihres freien traufseitigen Endes frei bleibt, so dass das abgeführte Wasser auf die freie Oberfläche der traufseitig angrenzenden horizontalen Reihe der Dacheindeckelemente abgeführt wird. Im Falle, dass die traufseitig angrenzende Reihe eine Solarbaugruppe ist, wird das Wasser auf die Oberfläche des Photovoltaik-Solarelements 11 dieser Solarbaugruppe abgeführt.

### Die Dacheindeckelemente der Solarbaugruppe und das gemeinsamene Photovoltaik-Solarelement

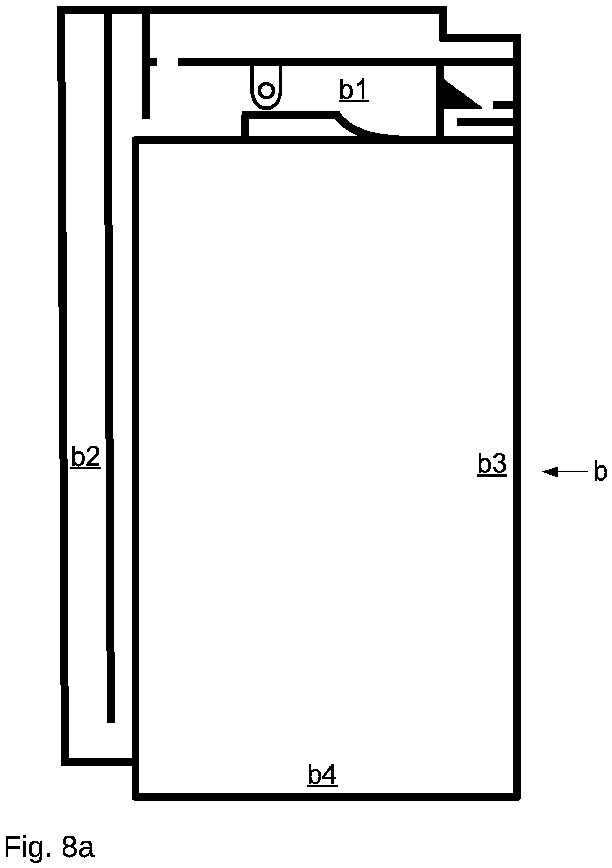

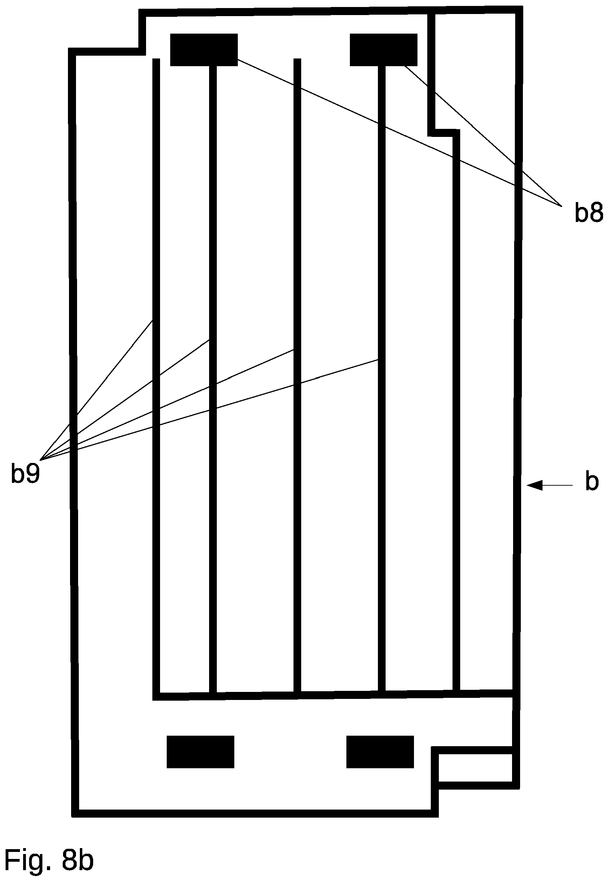

Nun zu den Dacheindeckelementen b, a der Solarbaugruppe und zum Aufbau der Solarbaugruppe: Die Basis-Dacheindeckelemente b unterscheiden sich von den Anschluss-Dacheindeckelementen a, wie folgt:
Das Basis-Dacheindeckelement b ist in Fig. 8a, 8b in Einzeldarstellung gezeigt. Das Basis-Dacheindeckelement b ist in seiner Baugröße, d.h. insbesondere in seiner Grundrichtung und in seinen Konturen genau gleich ausgebildet, wie das Anschluss-Dacheindeckelement a. Die Gleichheit in der Ausgestaltung ist derart, dass das Basis-Dacheindeckelement b und das Anschluss-Dacheindeckelement a in einem einheitlichen Verbund in der Solarbaugruppe und insbesondere auch mit den Dacheindeckelementen der gesamten Dacheindeckung verlegbar sind. In diesem Zusammenhang ist wesentlich, dass die Basis-Dacheindeckelemente b identisch sind mit den Dacheindeckelementen w der übrigen Dacheindeckung. Das Basis-Dacheindeckelement b weist auf seiner Oberseite ein ebenes Mittelfeld auf sowie einen Kopfwasserfalz b1, einen Seitenwasserfalz b2, einen Seitendeckfalz b3 und einen Fußdeckfalz b4. Der Kopfwasserfalz b1 und der Seitenwasserfalz b2 sind gegenüber dem Mittelfeld 10b tieferliegend in Art einer Stufe. Der Seitendeckfalz b3 und der Fußdeckfalz b4 hingegen erstrecken sich an das Mittelfeld anschließend fluchtend in der Ebene des Mittelfelds 10b. Diese Oberflächenabschnitte bilden eine zusammengesetzte ebene Oberfläche, die die freie Oberfläche des Basiseindeckelements b bildet. Diese freie Oberfläche ist die Oberfläche des Basis-Dacheindeckelements b, die in der Dacheindeckung nicht durch angrenzende Dacheindeckelemente überlappt wird.

Das Photovoltaik-Solarelement 11 weist bei den in Verbindung mit den Fig. 3, 4 und 5 beschriebenen Ausführungsbeispielen an seiner Unterseite jeweils neun Abschnitte auf, von denen jeder der freien Oberfläche eines der Dacheindeckelemente der Solarbaugruppe zugeordnet ist. Die neun Abschnitte der Unterseite des Photovoltaik-Solarelements liegen auf der freien Oberfläche der zugeordneten Dacheindeckelemente auf. In einem Abschnitt der Unterseite des Photovoltaik-Solarelements ist an der Unterseite ein elektrisches Anschlussaggregat 13 angeordnet. Dieser Abschnitt der Unterseite ist dem Anschluss-Dacheindeckelement a zugeordnet, d.h. dieser Abschnitt der Unterseite des Photovoltaik-Solarelements 11 liegt auf dem Anschluss-Dacheindeckelement a der Solarbaugruppe auf. Bei den dargestellten Ausführungsbeispielen ist das elektrische Anschlussaggregat 13 an der Unterseite eines endständigen Randabschnitts des Photovoltaik-Solarelements angeordnet. Dies korrespondiert damit, dass bei diesen Ausführungsbeispielen die Dacheindeckelemente a, b der Solarbaugruppe jeweils in horizontaler Reihe so angeordnet sind, dass das Anschluss-Dacheindeckelement a am Ende der Reihe angeordnet ist. Es sei verwiesen auf die Darstellungen in den Fig. 3, 4 und 5. Dort ist das Anschluss-Dacheindeckelement jeweils am rechten Ende der Reihe angeordnet. Das elektrische Anschlussaggregat ist elektrisch und mechanisch mit der Unterseite des Photovoltaik-Solarelements in dem rechten Endabschnitt verbunden. Im Bereich des frontseitigen rechten Randes weist das Photovoltaik-Solarelement auch noch ein elektrisches Anschlusskabel 14 auf, das am firstseitigen Rand des Photovoltaik-Solarelements herausgeführt ist.

Das elektrische Anschlusskabel 14 ist mit einer nicht dargestellten Peripherieeinrichtung verbunden, die vorzugsweise im Gebäude installiert ist.

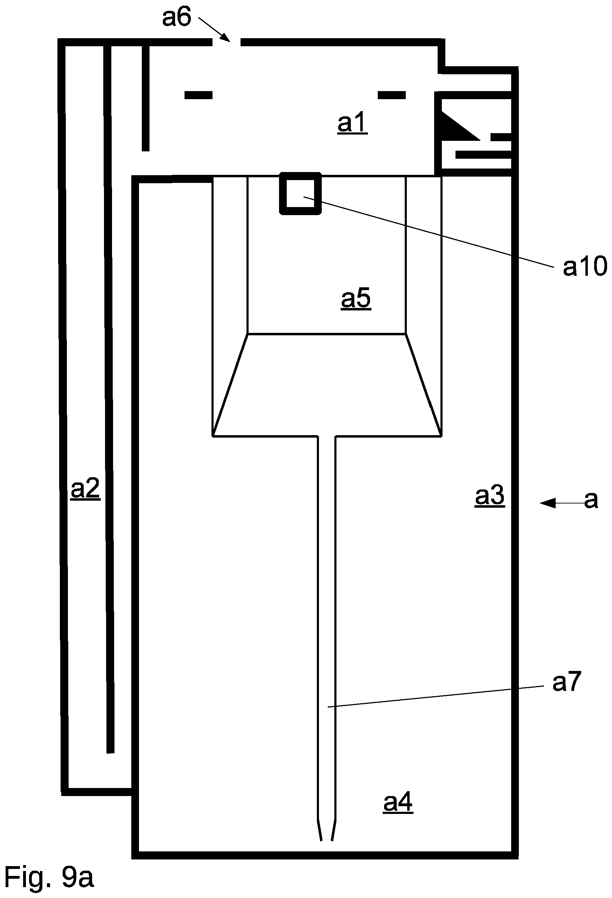

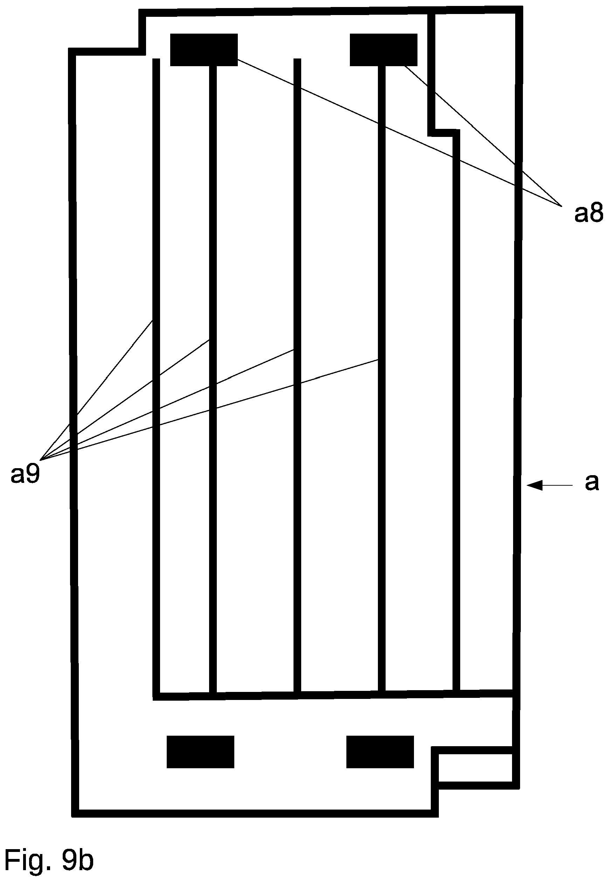

Das Anschluss-Dacheindeckelement a ist in Fig. 9a, 9b gezeigt. Das Anschluss-Dacheindeckelement a ist hinsichtlich seiner Größe, seines Grundrisses und seiner konstruktiven Gestaltung mit Kopfwasserfalz a1, Fußdeckfalz a4, Seitenwasserfalz a2 und Seitendeckfalz a3 identisch ausgebildet wie das Basis-Dacheindeckelement b. Es unterscheidet sich von dem Basis-Dacheindeckelement b jedoch darin, dass es auf der Oberseite in seinem Mittelfeld 10b eine Aufnahmevertiefung a5 und in seinem kopfseitigen oberen Abschnitt eine Kabeldurchführung a6 aufweist. Die Kabeldurchführung a6 ist als zur freien Oberseite des Dacheindeckelements hin offene Nut ausgebildet, die sich in der Linie Trauf/First senkrecht zum kopfseitigen Rand des Kopfwasserfalzes a1 des Anschluss-Dacheindeckelements a den kopfseitigen Rand durchquerend erstreckt.

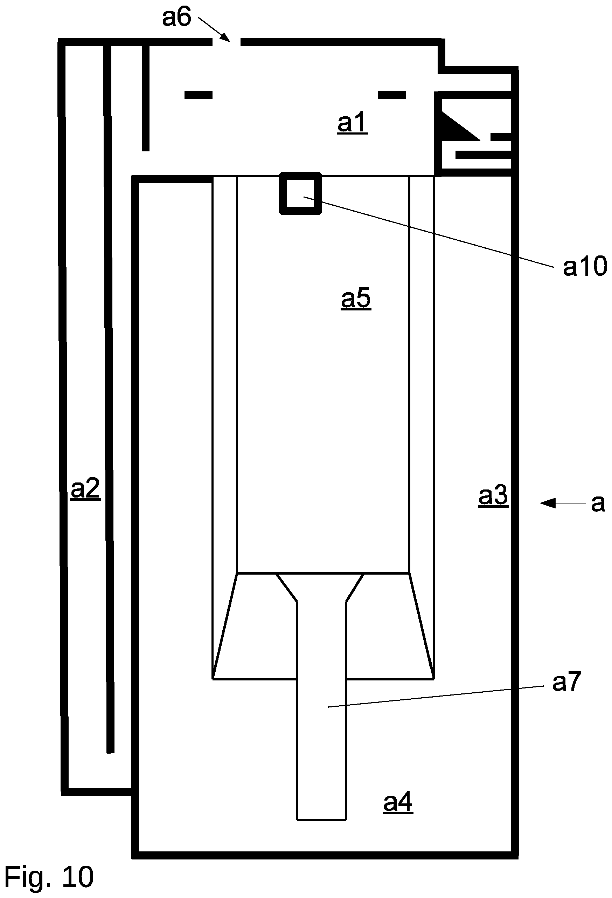

Die Aufnahmevertiefung a5 weist einen Wasserabfluss a7 auf, der bei dem Ausführungsbeispiel der Fig. 9a, 9b als in der Linie First/Trauf verlaufende zur freien Oberseite des Dacheindeckelements hin offene nutförmige Rinne eventuelles Regenwasser aus der Aufnahmevertiefung a5 auf den Fußdeckfalz a4 hin ableitet. Die Abflussrinne a7 verläuft in Richtung Trauf mit kontinuierlich abnehmender Tiefe und mündet damit auf der Oberfläche des Fußdeckfalzes a4 mit Abstand zu dem fußseitigen Rand des Fußdeckfalzes b4. Bei dem in Fig. 10 dargestellten weiteren Ausführungsbeispiel des Anschluss-Dacheindeckelements a erstreckt sich die Aufnahmevertiefung a5 weiter in Richtung Fußdeckfalz a4 und weist einen trichterartigen Einlauf in die Abflussrinne a7 auf, die breiter als beim Ausführungsbeispiel in Fig. 9a ist.

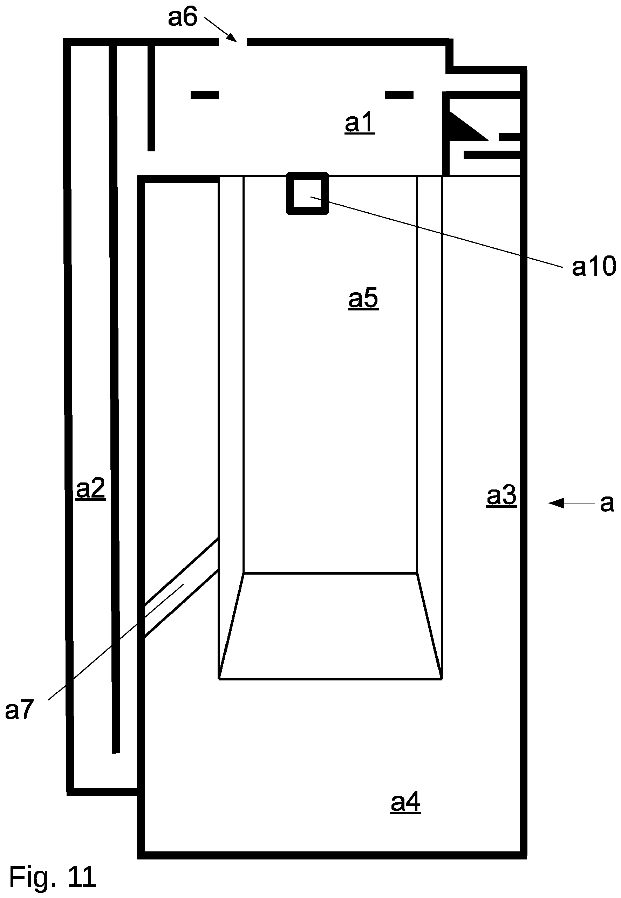

Bei dem in Fig. 11 dargestellten abgewandelten Ausführungsbeispiel des Anschluss-Dacheindeckelements a ist der Wasserabfluss a7 aus der Aufnahmevertiefung a5 durch eine schräg in den Seitenwasserfalz a2 ableitende Rinne ausgebildet, die die ebene freie Oberfläche schräg durchquert, die sich zwischen dem Seitenwasserfalz a2 und der Aufnahmevertiefung a5 erstreckt. Diese Wasserabführrinne ist ebenfalls zur freien Oberseite hin offen und mündet in den Seitenwasserfalz a2.

In der übrigen Gestaltung ist das Ausführungsbeispiel des Anschluss-Dacheindeckelements a in Fig. 11 identisch ausgebildet, wie das in Fig. 10 dargestellte Ausführungsbeispiel des Anschluss-Dacheindeckelements a. Bei den Ausführungsbeispielen des Anschluss-Dacheindeckelements a der Fig. 9a und b, 10 und 11 ist jeweils im Bereich des oberen Randes der Aufnahmevertiefung a5 ein Stützplateau a10 als ebene Fläche ausgebildet, um die firstseitig angrenzend angeordneten Dacheindeckelemente w abzustützen. Diese firstseitige angrenzenden Dacheindeckelemente w lagern in der Anordnung im Halberverband mit ihren Eckkanten des Fußdeckfalzes dort auf und sind dadurch gegen Kippen gesichert. Das Stützplateau 10a ist an seiner Oberseite also als Lagerplateau ausgebildet. Es ist fluchtend in der Ebene der freien Oberfläche des Anschluss-Dacheindeckelements a ausgebildet.

Die in dem Anschluss-Dacheindeckelement a ausgebildete Aufnahmevertiefung a5 und die im kopfseitigen Rand des Anschluss-Dacheindeckelements a ausgebildete Kabeldurchführung a6 sind zum Zusammenwirken mit dem Photovoltaik-Solarelement 11 ausgebildet:
Das an der Unterseite des Photovoltaik-Solarelements 11 angeordnete elektrische Anschlussaggregat 13 greift bei auf den Dacheindeckelementen a, b der Solarbaugruppen aufliegenden Photovoltaik-Solarelement 11 in die Aufnahmevertiefung a5 des Anschluss-Dacheindeckelements vollständig eintauchend ein. Das elektrische Anschlusskabel 14 durchgreift die im kopfseigen Rand des Anschlussdacheindeckelements a ausgebildeten Kabeldurchführung a6.

### Dacheindeckung mit vertikalen Solarbaugruppen

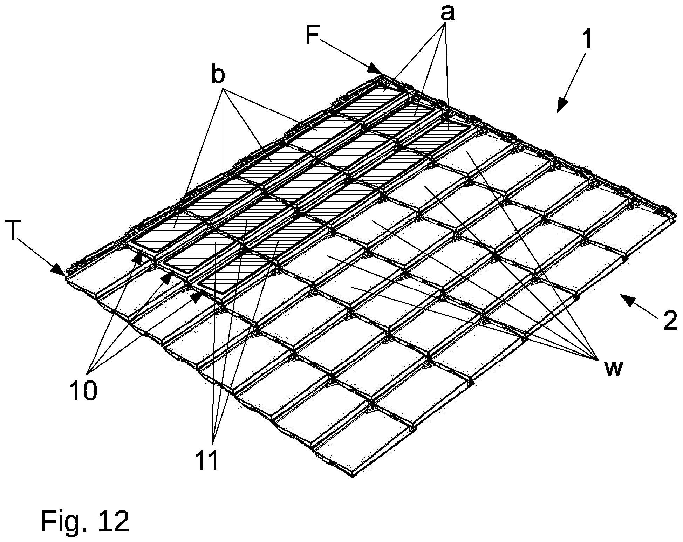

Bei dem in Fig. 12 bis 16 dargestellten Ausführungsbeispiel handelt es sich um eine Dacheindeckung 1 aus Dacheindeckelementen a, b, w auf einer Dachunterkonstruktion 2. Die Dacheindeckelemente a, b, w sind in der Dacheindeckung in parallelen vertikalen Reihen verlegt, d.h. in Reihen, die sich zwischen First und Trauf in der Falllinie erstrecken. Diese in der Falllinie verlaufenden Reihen werden als vertikale Reihen bezeichnet. Diese vertikalen Reihen sind jeweils parallel angeordnet und seitlich schuppenartig aneinandergrenzend in Art von Schuppen, die sich vertikal in der Falllinie erstrecken.

In der Dacheindeckung 1 in Fig. 12 sind vier parallele Solarbaugruppen 10 als vertikale Solarbaugruppen 10 jeweils seitlich schuppenartig aneinander angrenzend angeordnet. Jede solche vertikale Solarbaugruppe 10 ist durch ein Anschluss-Dacheindeckelement a und vier Basis-Dacheindeckelemente b gebildet, die in der Falllinie aneinander angrenzend angeordnet sind und über ein gemeinsames Photovoltaik-Solarelement 11 überdeckt sind. Die Dacheindeckelemente w der übrigen Dacheindeckung sind identisch ausgebildet, wie die Dacheindeckelemente b der Solarbaugruppen 10.

Das Photovoltaik-Solarelement 11 ist vergleichbar wie bei den vorangehenden Ausführungsbeispielen als im Grundriss rechteckiger Streifen ausgebildet und liegt mit seiner Unterseite auf der zusammengesetzten freien Oberfläche der Dacheindeckelemente a, b der Solarbaugruppe 10 auf. An seiner Unterseite weist das Photovoltaik-Solarelement 11 ein elektrisches Anschlussaggregat 13 auf, das in eine Aufnahmeausnehmung, d.h. eine Aufnahmevertiefung a5 des Anschluss-Dacheindeckelements a eintauchend eingreift. Das elektrische Anschlussaggregat 13 weist ein elektrisches Anschlusskabel 14 auf, das von dem elektrischen Anschlussaggregat 13 in Richtung First verläuft und dabei in einem im Kopfteil des Anschluss-Dacheindeckelements a ausgebildete Kabelaufnahme aufgenommen ist und durch einen im kopfseitigen Rand des Anschluss-Dacheindeckelements a ausgebildeten Kabeldurchbruchs a6 in die Dachunterkonstruktion 2 geführt ist. Das Anschlusskabel 14 ist an eine vorzugsweise im Gebäude installierte Peripherieeinrichtung anschließbar.

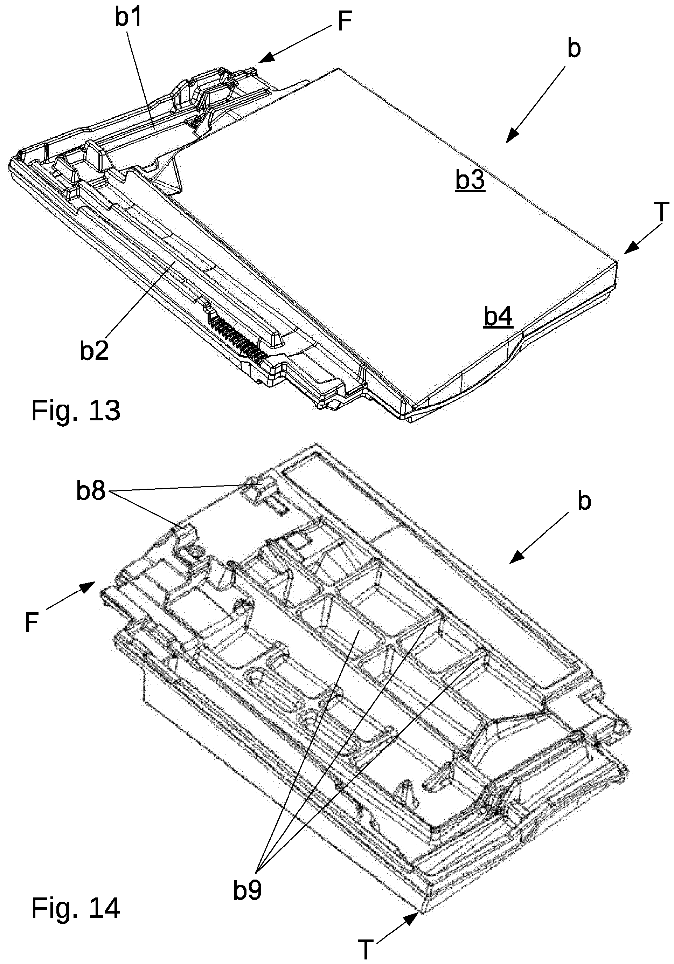

Das Basis-Dacheindeckelement b dieses Ausführungsbeispiels der Fig. 12 bis 16 ist in den Fig. 13 bis 15 in Einzeldarstellung dargestellt. Dieses Dacheindeckelement b ist gem. der DE 10 2013 010 169 A ausgebildet. Es handelt sich um einen durch Pressen herstellbaren Falzdachziegel mit einem dem First F zugewandten Kopfabschnitt und einem dem Kopfabschnitt gegenüberliegenden Fußabschnitt. Der Falzdachziegel weist einen Wasserfalzbereich b1, b2 und einen Deckfalzbereich b3, b4 auf, zwischen denen ein Mittelfeld ausgebildet ist.

Der Wasserfalzbereich b1, b2 und der Deckfalzbereich b3, b4 sind in Draufsicht des Falzdachziegels L-förmig ausgebildet, wobei die L-Schenkel jeweils einen rechten Winkel einschließen. Der Wasserfalzbereich weist einen seitlichen Wasserfalzschenkel b2 und einen kopfseitigen Wasserfalzschenkel b1 auf. Der Deckfalzbereich weist einen seitlichen Deckfalzschenkel b3 und einen fußseitigen Deckfalzschenkel b4 auf. Der Wasserfalzbereich und der Deckfalzbereich schließen mit der Innenseite ihrer Schenkel an dem Mittelfeld an. Der Wasserfalzbereich und der Deckfalzbereich sind so ausgebildet, dass im als Dacheindeckung verlegten Zustand bei benachbarten Falzdachziegeln der Deckfalzbereich b3, b4 des einen Falzdachziegels den Wasserfalzbereich b1, b2 des anderen Falzdachziegels überlappt.

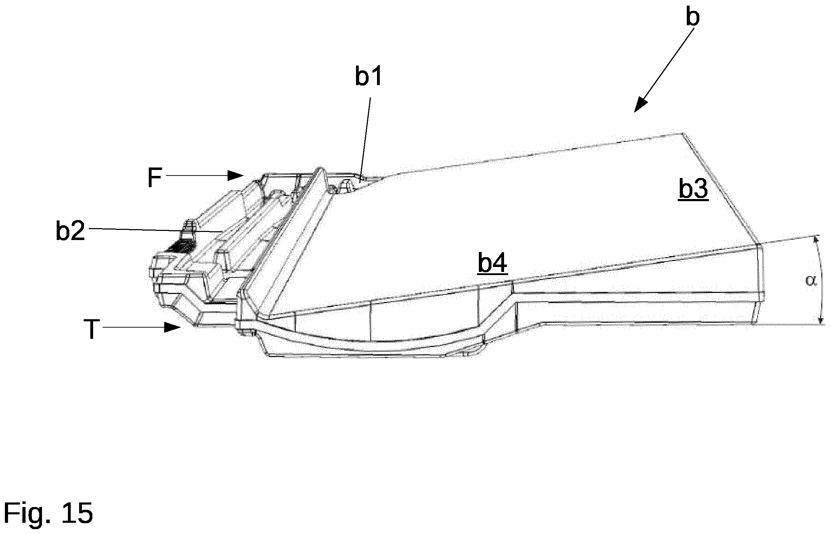

Die Oberseiten des Deckfalzbereichs und des Mittelfelds bilden eine ebene freie Oberfläche, die unter einem spitzen Neigungswinkel α zur Unterseite des seitlichen Deckfalzschenkels geneigt ist, wie in Fig. 15 dargestellt. In dem in den Fig. 12 bis 16 dargestellten Ausführungsbeispiel beträgt der Neigungswinkel α etwa 10°.

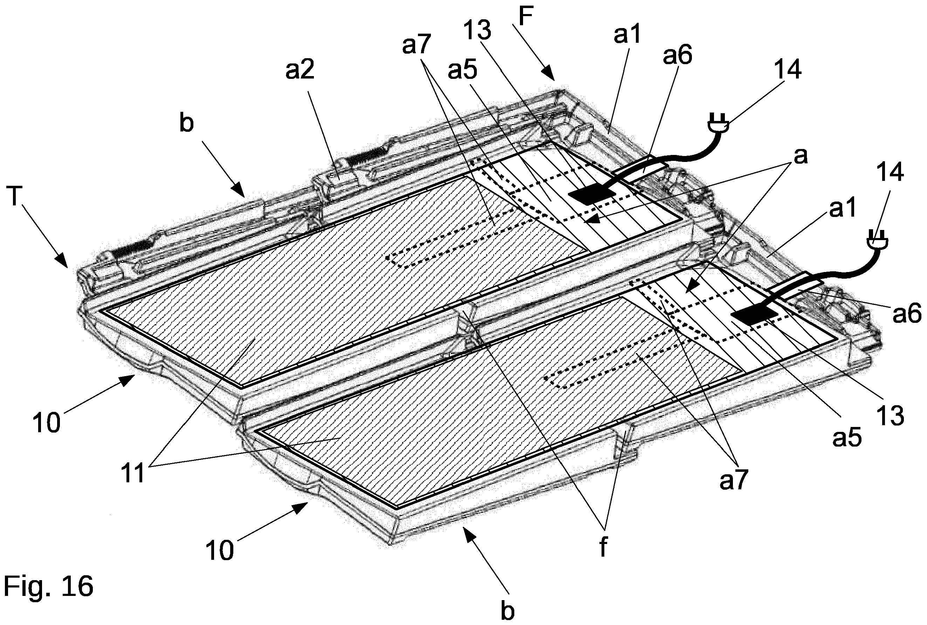

In der Dacheindeckung fluchten die ebenen freien Oberflächen der in vertikaler Reihe, d.h. in der Falllinie aneinander angrenzenden Dacheindeckelemente der Solarbaugruppe unter Ausbildung einer zusammengesetzten freien Oberfläche, die durch horizontale nutenförmige Abstandsfugen f rasterartig unterbrochen ist (siehe. Fig. 16):
Das Anschluss-Dacheindeckelement a weist die gleiche Baugröße und den gleichen konstruktiven Aufbau wie das Basis-Dacheindeckelement b auf. Das Anschluss-Dacheindeckelement a unterscheidet sich von dem Basis-Dacheindeckelement b dadurch, dass das Anschluss-Dacheindeckelement a in seinem Mittelfeld an der Oberseite eine Aufnahmevertiefung a5 zur Aufnahme des elektrischen Anschlussaggregats 13 und einen die Aufnahmevertiefung a5 entwässernden kanalförmigen Wasserablauf a7 aufweist. Die Aufnahmevertiefung a5 und der Wasserablauf a7 ist in Fig. 16 eingezeichnet.

Der Wasserablauf a7 kann, ausgehend von der Aufnahmevertiefung a5, in der Falllinie verlaufend ausgebildet sein und in die traufseitig ausgebildete horizontale nutenförmige Abstandsfuge entwässern. Alternativ kann der Wasserabflusskanal a7 auch, ausgehend von der Aufnahmevertiefung a5 zur Seite hin in den Seitenwasserfalz a2 des Falzdachziegels entwässern. In diesem Fall verläuft der Wasserabflusskanal a7 spitzwinkelig geneigt zur Horizontalen ausgehend von dem traufseitigen Ende der Aufnahmevertiefung a5. Es sind auch Ausführungsbeispiele möglich, bei denen der Falzdachziegel sowohl einen in der Falllinie verlaufenden Wasserabflusskanal a7 und zusätzlich einen seitlich in den Seitenwasserfalz a2 verlaufenden Wasserabflusskanal a7 aufweist. Dieser Fall ist in Fig. 16 dargestellt.

In dem Kopfwasserfalz 1 des Anschluss-Dacheindeckelements a ist eine Kabelaufnahme, die im kopfseitigen Rand des Anschluss-Dacheindeckelements a einen Kabeldurchbruch aufweist, so dass das elektrische Anschlusskabel 14, welches ausgehend von dem an der Unterseite des Photovoltaik-Solarelements 11 angeordneten elektrischen Anschlussaggregat 13, welches in die Aufnahmevertiefung a5 eintauchend angeordnet ist, wie vorangehend beschrieben firstseitig in die Dachunterkonstruktion geführt werden kann.

Das Photovoltaik-Solarelement 11 liegt mit seiner Unterseite auf der zusammengesetzten ebenen freien Oberfläche der in vertikaler Reihe, d.h. in der Falllinie aneinander angrenzenden Dacheindeckelemente a, b der Solarbaugruppe 10 auf (siehe Fig. 16). Bei den Dacheindeckelementen der Solarbaugruppe 10 handelt es sich bei dem schematischen Ausführungsbeispiel in Fig. 12 um jeweils vier Basis-Dacheindeckelemente b und ein Anschluss-Dacheindeckelement a. Die zwischen den jeweils ebenen freien Oberflächen der Dacheindeckelemente b, a ausgebildeten horizontalen Abstandsfugen werden dabei von dem Photovoltaik-Solarelement 11 übergriffen. Es sind Ausführungen möglich, bei denen die vertikalen Solarbaugruppen 10 - abweichend von der schematischen Darstellung in Fig. 12 - auch eine andere Anzahl von Basis-Dacheindeckelementen b und Anschluss-Dacheindeckelementen a aufweisen.

### Bezugszeichenliste

- 1: Dacheindeckung
- 2: Dachunterkonstruktion
- 2h: horizontale Dachlatte
- 2s: schräger Dachsparren
- 10: Solarbaugruppe
- 11: Photovoltaik-Solarelement
- 13: elektrisches Anschlussaggregat
- 14: elektrisches Anschlusskabel
- 15: Befestigungselement

- a: Anschluss-Dacheindeckelement
- a1: Kopfwasserfalz
- a2: Seitenwasserfalz
- a3: Seitendeckfalz
- a4: Fußdeckfalz
- a5: Aufnahmevertiefung
- a6: Kabeldurchbruch
- a7: Wasserabfluss
- a8: Einhängenase an der Unterseite
- a9: Stützrippe
- a10: Auflagefläche des Auflageplateaus
- a15: Befestigungselement

- b: Basis-Dacheindeckelement
- b1: Kopfwasserfalz
- b2: Seitenwasserfalz
- b3: Seitendeckfalz
- b4: Fußdeckfalz
- b8: Einhängenase an der Unterseite
- b9: Stützrippe
- b15: Befestigungselement

- w: Dacheindeckelement der übrigen Dacheindeckung, identisch ausgebildet wie das Basis-Dacheindeckelement b
- w1: Kopfwasserfalz
- w2: Seitenwasserfalz
- w3: Seitendeckfalz
- w4: Fußdeckfalz
- w8: Einhängenase an der Unterseite
- w10: Auflagefläche

- F: First
- T: Trauf

## Patentansprüche

1. Dacheindeckung (1) für mindestens einen Abschnitt eines Daches mit Dachschräge,
umfassend Dacheindeckelemente, die auf einer eine Dachschräge aufweisende Dachunterkonstruktion (2) aneinander angrenzend, vorzugsweise im Verbund angeordnet sind,
wobei mindestens eine Gruppe der aneinandergrenzenden Dacheindeckelemente mindestens eine Solarbaugruppe (10) bildet,
wobei die Dacheindeckelemente der Solarbaugruppe (10) in einer vorgegebenen Anordnungsstruktur aneinander angrenzend angeordnet sind, nämlich in einer horizontalen Reihe oder in einer vertikalen Reihe oder in mehreren aneinandergrenzenden horizontalen Reihen oder in mehreren aneinander angrenzenden vertikalen Reihen und wobei die freien Oberflächen der Dacheindeckelemente der Solarbaugruppe eine zusammengesetzte freie Oberfläche bilden, auf der ein Photovoltaik-Solarelement (11), das als gemeinsames Photovoltaik-Solarelement (11) der Solarbaugruppe (10) ausgebildet ist, mit seiner Unterseite aufliegend angeordnet ist,
**wobei**
i) dass die Dacheindeckelemente der mindestens einen Solarbaugruppe (10) als Dacheindeckelemente ausgebildet sind, von denen mindestens eines jeweils als Anschluss-Dacheindeckelement (a) ausgebildet ist und alle übrigen jeweils als Basis-Dacheindeckelement (b) ausgebildet sind, wobei jedes der Dacheindeckelemente der Solarbaugruppe (10) eine freie Oberfläche aufweist, die gemeinsam mit den übrigen Dacheindeckelementen der Solarbaugruppe (10) die zusammengesetzte freie Oberfläche der Dacheindeckelemente der Solarbaugruppe (10) bildet, auf der das Photovoltaik-Solarelement (11) der Solarbaugruppe (10) aufliegend und sämtliche Dacheindeckelemente der Solarbaugruppe übergreifend angeordnet ist,
ii) die Dacheindeckelemente der übrigen Dacheindeckung, d.h. der nicht als Solarbaugruppe ausgebildeten Dacheindeckung als Basis-Dacheindeckelemente (b) ausgebildet sind, die identisch mit den Basis-Dacheindeckelementen (b) der Solarbaugruppe (10) ausgebildet sind,
iii) das Anschluss-Dacheindeckelement (a) in Formgestaltung und Abmessungen gleich ausgebildet ist, wie das Basis-Dacheindeckelement (b), jedoch mit dem Unterschied, dass in der freien Oberfläche des Anschluss-Dacheindeckelements (a) eine Aufnahmeausnehmung (a5) zur Aufnahme eines an der Unterseite des Photovoltaik-Solarelements (11) angeordneten elektrischen Anschlussaggregats (13) des Photovoltaik-Solarelements (11) ausgebildet ist und nur die freie Oberfläche des Anschluss-Dacheindeckelements (a), die sich außerhalb der Aufnahmeausnehmung (a5) erstreckt, als eine freie Oberfläche des Anschluss-Dacheindeckelements (a) ausgebildet ist, auf der ein zugeordneter Abschnitt des Photovoltaik-Solarelements (11) aufliegend, die freie Oberfläche des Anschluss-Dacheindeckelements (a) einschließlich die Aufnahmeausnehmung (a5) übergreifend angeordnet ist, wobei der Boden des Anschluss-Dacheindeckelements (a), welcher die Aufnahmeausnehmung (a5) für das elektrische Anschlussaggregat (13) des Photovoltaik-Solarelements (11) und vorzugsweise auch eine Kabelführungseinrichtung (a6) für ein Anschlusskabel (14) des elektrischen Anschlussaggregats (13) aufweist, in der Dacheindeckung in keinem der Dachunterkonstruktion (2) zugewandten Bodenabschnitt eine Öffnung aufweist, die einen Durchtritt von Wasser und/oder Flugfeuer zur Dachunterkonstruktion (2) hin zulässt, und
wobei das Anschluss-Dacheindeckelement (a) und/oder das Basis-Dacheindeckelement (b) einen Kopfwasserfalz (a1, b1) und einen Fußdeckfalz (a4, b4) aufweist und/oder einen Seitenwasserfalz (a2, b2) und einen Seitendeckfalz (a3, b3) aufweist, und
wobei von der in dem Anschluss-Dacheindeckelement (a) ausgebildeten Aufnahmeausnehmung (a5) eine Wasserabflusseinrichtung (a7) ausgeht,
v) wobei die Wasserabflusseinreichung (a7) zum Fuß der Abschluss-Dacheindeckelements (a) hin ableitet, und zwar auf die Oberseite des Fußdeckfalzes (a4) des Anschluss-Dacheindeckelements (a) und/oder auf das in der Dacheindeckung traufseitig angeordnete Dacheindeckelement (a, b, w) der Dacheindeckung, vorzugsweise in dem Kopfwasserfalz (a1, b1) und/oder auf dessen freie Oberfläche und/oder auf einem auf dessen freier Oberfläche angeordnetes Photovoltaik-Solarelement (11),
und/oder
vv) wobei die Wasserabflusseinrichtung (a7) zum Seitenrand des Anschluss-Dacheindeckelements (a) ableitet und zwar zum Seitenwasserfalz (a2) des Anschluss-Dacheindeckelements (a) hin und/oder auf den Seitendeckfalz (a3) des Anschluss-Dacheindeckelements (a) und von da auf ein in der Dacheindeckung seitlich benachbart angeordnetes Dacheindeckelement (a, b, w) der Dacheindeckung, vorzugsweise in dessen Seitenwasserfalz und/oder auf dessen freie Oberfläche und/oder auf ein auf dessen freier Oberfläche angeordnetes Photovoltaik-Element (11).

2. Dacheindeckung nach Anspruch 1,
**dadurch gekennzeichnet,**
**dass** in dem Anschluss-Dacheindeckelement (a) die Aufnahmeausnehmung (a5)
- an dem fußseitigen Rand des Kopfwasserfalzes (a1) anschließt, vorzugsweise die Aufnahmeausnehmung (a5) und der Kopfwasserfalz (a1) ineinander übergehen, und/oder
- an dem Seitenwasserfalz (a2) anschließt, vorzugsweise die Aufnahmeausnehmung (a5) und der Seitenwasserfalz (a2) ineinander übergehen.

3. Dacheindeckung nach einem der vorangehenden Ansprüche,
**dadurch gekennzeichnet,**
**dass** die Wasserabflusseinrichtung (a7) eine im Boden des Anschluss-Dacheindeckelements (a) vorzugsweise ausgeformte Wasserführungseinrichtung aufweist, die als Wasserabführung (a7) ausgebildet ist, z.B. als Wasserführungsnut, Wasserführungsrinne, Wasserführungskanal.

4. Dacheindeckung nach einem der vorangehenden Ansprüche,
**dadurch gekennzeichnet,**
**dass** ein Übergangsbereich zwischen der Aufnahmeausnehmung (a5) und der Wasserabführung (a7) trichterförmig ausgebildet ist.

5. Dacheindeckung nach einem der vorangehenden Ansprüche,
**dadurch gekennzeichnet,**
**dass** die Wasserabführung (a7) im Verlauf von der Aufnahmeausnehmung (a5) hin zum Ausmündungsende der Wasserführung (a7) abnehmende Tiefe aufweist.

6. Dacheindeckung nach einem der vorangehenden Ansprüche,
**dadurch gekennzeichnet,**
**dass** das Anschluss-Dacheindeckelement (a) und/oder das Photovoltaik-Solarelement (11) eine Kabelführungseinrichtung (a6) aufweist, in der das Anschlusskabel (14) des elektrischen Anschlussaggregats (13) der elektrischen Anschlusseinrichtung des Photovoltaik-Solarelements (11) zumindest abschnittsweise angeordnet ist.

7. Dacheindeckung nach Anspruch 6,
**dadurch gekennzeichnet,**
i) **dass** die Kabelführungseinrichtung (a6) oder zumindest ein Abschnitt der Kabelführungseinrichtung (a6) in einem Mantel des Photovoltaik-Solarelements (11) angeordnet ist und/oder
ii) **dass** die Kabelführungseinrichtung (a6) oder zumindest ein Abschnitt der Kabelführungseinrichtung (a6) im Kopfwasserfalz (a1) oder im Seitenwasserfalz (a2) des Anschluss-Dacheindeckelements (a) angeordnet ist und/oder
iii) **dass** die Kabelführungseinrichtung (a6) oder zumindest ein Abschnitt der Kabelführungseinrichtung (a6) in einem kopfseitigen oder fußseitigen oder seitlich äußeren Rand des Anschluss-Dacheindeckelements (a) vorzugsweise den Rand durchgreifend und/oder übergreifend angeordnet ist und/oder
iv) **dass** die Kabelführungseinrichtung (a6) oder zumindest ein Abschnitt der Kabelführungseinrichtung (a6) auf der Oberseite des Bodens des Anschluss-Dacheindeckelements (a) in einem Bereich des Bodens außerhalb der Aufnahmeausnehmung (a5) angeordnet ist und/oder
v) **dass** die Kabelführungseinrichtung (a6) oder zumindest ein Abschnitt der Kabelführungseinrichtung (a6) im Boden der Aufnahmeausnehmung (a5) und/oder im oberen Randbereich der Aufnahmeausnehmung (a5) angeordnet ist.

8. Dacheindeckung nach einem der Ansprüche 6 oder 7,
**dadurch gekennzeichnet,**
**dass** die Kabelführungseinrichtung (a6) in dem Anschluss-Dacheindeckelement (a) ausschließlich an der nach oben gewandten Oberseite des Anschluss-Dacheindeckelements (a) ausgebildet ist, ohne dass das darin angeordnete Anschlusskabel (14) eine Öffnung im Boden von der Oberseite zur Unterseite hin durchgreift oder umgekehrt von der Unterseite zur Oberseite hin durchgreift.

9. Dacheindeckung nach einem der Ansprüche 6 bis 8,
**dadurch gekennzeichnet,**
**dass** die Kabelführung (a6) in dem Anschluss-Dacheindeckelement (a) als nach oben offene bodenseitig oder randseitig angeordnete Vertiefung (a6), vorzugsweise Nut (a6) ausgebildet ist oder als ein nach oben geschlossener und/oder umfangsseitig geschlossener bodenseitig oder randseitig angeordneter Kanal oder Durchbruch ausgebildet ist.

10. Dacheindeckung nach einem der Ansprüche 6 bis 9,
**dadurch gekennzeichnet,**
**dass** die Kabelführungseinrichtung (a6) eine zugeordnete separate Wasserabflusseinrichtung aufweist, oder dass die Kabelführungseinrichtung (a6) mit der Wasserabflusseinrichtung (a7) der Aufnahmeausnehmung (a5) verbunden ist, vorzugsweise innerhalb der Wasserabflusseinrichtung (a7) der Aufnahmeausnehmung (a5) angeordnet.

11. Dacheindeckung nach einem der vorangehenden Ansprüche,
**dadurch gekennzeichnet,**
**dass** in dem Anschluss-Dacheindeckelement (a) in der Aufnahmeausnehmung (a5) oder angrenzend an die Aufnahmeausnehmung (a5) ein als Erhebung ausgebildetes Auflagerplateau (a10), das eine freie Oberfläche aufweist, die als Auflagerfläche (a10) ausgebildet ist, auf der ein firstseitig angrenzendes Dacheindeckelement oder zwei firstseitig angrenzende Dacheindeckelemente mit ihren fußseitigen Rand auflagert bzw. auflagern.

12. Dacheindeckung nach einem der vorangehenden Ansprüche,
**dadurch gekennzeichnet,**
**dass** das auf der freien Oberfläche der Dacheindeckelemente (a, b) der Solarbaugruppe (10) aufliegende Photovoltaik-Solarelement (11) nicht auf dem Kopfwasserfalz (a1, b1) und/oder dem Seitenwasserfalz (a2, b2) der Dacheindeckelemente der Solarbaugruppe (10) aufliegend angeordnet ist und nicht den Kopfwasserfalz (a1, b1) und/oder den Seitenwasserfalz (a2, b2) übergreift und/oder überdeckt.

13. Dacheindeckung nach einem der vorangehenden Ansprüche,
**dadurch gekennzeichnet,**
**dass** das Photovoltaik-Solarelement (11), das auf der zusammengesetzten freien Oberfläche der Dacheindeckelemente (a, b) der Solarbaugruppe (10) aufliegt, auf den Dacheindeckelementen der Solarbaugruppe (10) über eine formschlüssige mechanische Verbindung und/oder eine magnetische Verbindung und/oder eine Klebeverbindung befestigt ist.

14. Dacheindeckung nach einem der vorangehenden Ansprüche,
**dadurch gekennzeichnet,**
**dass** die Dacheindeckelemente in der Dacheindeckung, vorzugsweise in der Dacheindeckung, die die mindestens eine Solarbaugruppe (10) aufweist oder an die mindestens eine Solarbaugruppe (10) angrenzt, derart angeordnet sind,
a) **dass** die in First-/Traufrichtung aneinander angrenzenden horizontalen Reihen der Dacheindeckelemente schuppenartig unter Ausbildung einer Art horizontaler Schuppen überlappen, vorzugsweise der traufseitige Rand und/oder Abschnitt des firstseitig angeordneten Dacheindeckelements den firstseitigen Rand und/oder Abschnitt des traufseitig angeordneten Dacheindeckelements übergreift, oder
b) **dass** die in seitlicher Richtung aneinander angrenzenden vertikalen Reihen der Dacheindeckelemente schuppenartig unter Ausbildung einer Art vertikaler Schuppen überlappen, vorzugsweise der linksseitige Rand und/oder Abschnitt des rechtsseitig angeordneten Dacheindeckelements den rechtsseitigen Rand und/oder Abschnitt des linksseitig angeordneten Dacheindeckelements übergreift.

15. Dacheindeckung nach einem der vorangehenden Ansprüche,
**dadurch gekennzeichnet,**
**dass** das Basis-Dacheindeckelement (b) der Solarbaugruppe (10) aus Keramikmaterial und/oder Zementmaterial und/oder metallischem Material ausgebildet ist, und/oder
**dass** das Anschluss-Dacheindeckelement (a) der Solarbaugruppe (10) aus Keramikmaterial und/oder Zementmaterial und/oder metallischem Material und/oder Kunststoffmaterial ausgebildet ist, und/oder
**dass** die Dacheindeckelemente der übrigen Dacheindeckung aus Keramikmaterial und/oder Zementmaterial und/oder metallischem Material ausgebildet sind.

## Claims

1. Roof covering (1) for at least a section of a roof having a roof pitch,
comprising roof covering elements which are arranged adjacent to one another, preferably in connection, on a roof substructure (2) having a roof pitch, wherein at least one group of the roof covering elements adjacent to one another forms at least one solar assembly (10), wherein the roof covering elements of the solar assembly (10) are arranged in a predetermined arrangement structure, adjacent to one another, specifically in a horizontal array or in a vertical array or in multiple adjacent horizontal arrays or in multiple adjacent vertical arrays, and wherein the free surfaces of the roof covering elements of the solar assembly form a composite free surface, on which a photovoltaic solar element (11) that is formed as a photovoltaic solar element (11) in common with the solar assembly (10), is arranged with its underside overlying, wherein
i) the roof covering elements of the at least one solar assembly (10) are formed as roof covering elements, at least one of which is respectively formed as a connecting roof covering element (a) and all remaining are respectively formed as a base roof covering element (b), wherein each roof covering element of the solar assembly (10) has a free surface which, together with the remaining roof covering elements of the solar assembly (10), forms the composite free surface of the roof covering elements of the solar assembly (10), on which the photovoltaic solar element (11) of the solar assembly (10) is arranged so as to overly and overlap all roof covering elements of the solar assembly,
ii) the roof covering elements of the remaining roof covering, i.e. of the roof covering not formed as a solar assembly, are formed as a base roof covering elements (b) which are formed identically with the base roof covering elements (b) of the solar assembly (10),
iii) the connecting roof covering element (a) is formed the same in design and dimensions as the base roof covering element (b), but with the difference that a receiving recess (a5) for receiving an electrical connection unit (13) of the photovoltaic solar element (11) arranged on the underside of the photovoltaic solar element (11) is formed in the free surface of the connecting roof covering element (a) and only the free surface of the connecting roof covering element (a), which extends outside the receiving recess (a5), is formed as a free surface of the connecting roof covering element (a) on which an associated section of the photovoltaic solar element (11) is arranged overlying, the free surface of the connecting roof covering element (a) including the receiving recess (a5) is arranged to overlap, wherein the base of the connecting roof covering element (a), which base has the receiving recess (a5) for the electrical connection unit (13) of the photovoltaic solar element (11), and preferably also a has a cable guiding device (a6) for a connection cable (14) of the electrical connection unit (13), does not have an opening in the roof covering in any base section facing the roof substructure (2), which opening permits the passage of water and/or flying sparks towards the roof substructure (2), and wherein the connecting roof covering element (a) and/or the base roof covering element (b) has a head water trough (a1, b 1) and a foot cover trough (a4, b4) and/or has a side water trough (a2, b2) and a side cover trough (a3, b3), and wherein a water drainage device (a7) extends from the receiving recess (a5) formed in the connecting roof covering element (a),
v) wherein the water drainage device (a7) discharges at the foot of the connecting roof covering element (a), specifically onto the upper side of the foot cover trough (a4) of the connecting roof covering element (a) and/or onto the roof covering element (a, b, w) of the roof covering, arranged on the eave side in the roof covering, preferably in the head water trough (a1, b1) and/or on its free surface and/or on a photovoltaic solar element (11) arranged on its free surface, and/or
vi) wherein the water drainage device (a7) discharges to the side edge of the connecting roof covering element (a) and specifically to the side water trough (a2) of the connecting roof covering element (a) and/or to the side cover trough (a3) of the connecting roof covering element (a) and from there onto a roof covering element (a, b, w) of the roof covering arranged laterally adjacent in the roof covering, preferably in its side water trough and/or to its free surface and/or to a photovoltaic element (11) arranged on its free surface.

2. Roof covering according to claim 1,
**characterised in that,**
in the connecting roof covering element (a), the receiving recess (a5)
- borders the foot-side edge of the head water trough (a1), preferably the receiving recess (a5) and the head water trough (a1) pass into each other, and/or
- borders the side water trough (a2), preferably the receiving recess (a5) and the side water trough (a2) pass into each other.

3. Roof covering according to one of the preceding claims,
**characterised in that,**
the water drainage device (a7) has a water guiding device preferably formed in the base of the connecting roof covering element (a), which is formed as water discharge (a7), e.g. as a water guiding groove, water guiding conduit, water guiding channel.

4. Roof covering according to one of the preceding claims,
**characterised in that,**
a transition region between the receiving recess (a5) and the water discharge (a7) is formed in a funnel shape.

5. Roof covering according to one of the preceding claims,
**characterised in that,**
the water discharge (a7) has decreasing depth in the course from the receiving recess (a5) to the mouth end of the water guide (a7).

6. Roof covering according to one of the preceding claims,
**characterised in that,**
the connecting roof covering (a) and/or the photovoltaic solar element (11) has a cable guiding device (a6) in which the connection cable (14) of the electrical connection unit (13) of the electrical connection device of the photo-voltaic solar element (11) is arranged at least in sections.

7. Roof covering according to claim 6,
**characterised in that,**
i) the cable guiding device (a6) or at least a section of the cable guiding device (a6) is arranged in a shell of the photovoltaic solar element (11) and/or
ii) the cable guiding device (a6) or at least a section of the cable guiding device (a6) is arranged in the head water trough (a1) or in the side water trough (a2) of the connecting roof covering element (a) and/or
iii) the cable guiding device (a6) or at least a section of the cable guiding device (a6) is arranged in a head-sided or foot-sided or laterally external edge of the connecting roof covering element (a) preferably in a manner that engages through and/or overlaps with the edge, and/or
iv) the cable guiding device (a6) or at least a section of the cable guiding device (a6) is arranged on the upper side of the base of the connecting roof covering element (a) in a region of the base outside the receiving recess (a5), and/or
v) the cable guiding device (a6) or at least a section of the cable guiding device (a6) is arranged in the base of the receiving recess (a5) and/or in the upper edge region of the receiving recess (a5).

8. Roof covering according to one of claims 6 or 7,
**characterised in that,**
the cable guiding device (a6) in the connecting roof covering element (a) is formed exclusively on the upward-facing upper side of the connecting roof covering element (a), without the connection cable (14) arranged therein passing through an opening in the base from the upper side to the underside or vice versa passing through from the underside to the upper side.

9. Roof covering according to one of claims 6 to 8,
**characterised in that,**
the cable guide (a6) in the connecting roof covering element (a) is formed as an upwardly open recess (a6), preferably a groove (a6), arranged on the base or edge, or is formed as an upwardly closed and/or peripherally closed channel or aperture arranged on the base or edge.

10. Roof covering according to one of claims 6 to 9,
**characterised in that,**
the cable guiding device (a6) has an assigned separate water discharge device, or the cable guiding device (a6) is connected with the water discharge device (a7) of the receiving recess (a5), preferably arranged inside the water discharge device (a7) of the receiving recess (a5).

11. Roof covering according to one of the preceding claims,
**characterised in that,**
in the connecting roof covering element (a) in the receiving recess (a5) or adjacent to the receiving recess (a5), there is a support plateau (a10) formed as an elevation, which has a free surface that is designed as a support surface (a10), on which a roof covering element adjacent to the ridge or two roof covering elements adjacent to the ridge rests or rest with their foot-side edge.

12. Roof covering according to one of the preceding claims,
**characterised in that,**
the photovoltaic solar element (11) resting on the free surface of the roof covering elements (a, b) of the solar assembly (10) is not arranged to rest on the head water trough (a1, b1) and/or the side water trough (a2, b2) of the roof covering elements of the solar assembly (10) and does not overlap and/or cover the head water trough (a1, b1) and/or the side water trough (a2, b2).

13. Roof covering according to one of the preceding claims,
**characterised in that,**
the photovoltaic solar element (11), which rests on the composite free surface of the roof covering elements (a, b) of the solar assembly (10), is fastened to the roof covering elements of the solar assembly (10) by means of a form-fit mechanical connection and/or a magnetic connection and/or an adhesive connection.

14. Roof covering according to one of the preceding claims,
**characterised in that,**
the roof covering elements are arranged in the roof covering, preferably in the roof covering which has the at least one solar assembly (10) or to which at least one solar assembly (10) is adjacent, in such a way that,
a) the horizontal arrays of the roof covering elements adjoining one another in the ridge/eave direction overlap like scales, forming a type of horizontal scales, preferably the eaves-side edge and/or section of the ridge-side of the roof covering element overlaps the ridge-side edge and/or section of the eaves-side roof covering element, or
b) the vertical arrays of the roof covering elements adjoining one another in the lateral direction overlap like scales, forming a type of vertical scales, preferably the left-hand edge and/or section of the roof covering element arranged on the right-hand side overlaps the right-hand edge and/or section of the roof covering element arranged on the left-hand side.

15. Roof covering according to one of the preceding claims,
**characterised in that,**
the base roof covering element (b) of the solar assembly (10) is made of ceramic material and/or cement material and/or metallic material, and/or
the connecting roof covering element (a) of the solar assembly (10) is made of ceramic material and/or cement material and/or metallic material and/or synthetic material, and/or
the roof covering elements of the remaining roof covering is made of ceramic material and/or cement material and/or metallic material.

## Revendications

1. Recouvrement de toit (1) pour au moins une portion d'un toit avec une pente de toit,
comprenant des éléments de recouvrement de toit, qui sont disposés de manière adjacente, de préférence de manière combinée, entre eux sur une infrastructure de toit (2) présentant une pente de toit,
dans lequel au moins un groupe des éléments de recouvrement de toit adjacents entre eux constitue au moins un module solaire (10),
dans lequel les éléments de recouvrement de toit du module solaire (10) sont disposés de manière adjacente entre eux dans une structure de disposition prédéterminée, à savoir dans une rangée horizontale ou dans une rangée verticale ou dans plusieurs rangées horizontales adjacentes entre elles ou dans plusieurs rangées verticales adjacentes entre elles et dans lequel les surfaces libres des éléments de recouvrement de toit du module solaire constituent une surface libre composée sur laquelle un élément solaire photovoltaïque (11), qui est conçu comme un élément solaire photovoltaïque (11) commun du module solaire (10), est disposé de façon à reposer avec sa face inférieure,
dans lequel
i) les éléments de recouvrement de toit de l'au moins un module solaire (10) sont conçus comme des éléments de recouvrement de toit dont au moins un est conçu respectivement comme un élément de recouvrement de toit de raccordement (a) et tous les autres sont conçus respectivement comme des éléments de recouvrement de toit de base (b), dans lequel chacun des éléments de recouvrement de toit du module solaire (10) présente une surface libre qui constitue, conjointement avec les autres éléments de recouvrement de toit du module solaire (10), la surface libre composée des éléments de recouvrement de toit du module solaire (10), sur laquelle l'élément solaire photovoltaïque (11) du module solaire (10) est posé et est disposé de façon à englober l'ensemble des éléments de recouvrement de toit du module solaire,
ii) les éléments de recouvrement de toit du reste du recouvrement de toit, c'est-à-dire le recouvrement de toit non conçu comme un module solaire, sont conçus comme des éléments de recouvrement de toit de base (b), qui sont identiques aux éléments de recouvrement de toit de base (b) du module solaire (10),
iii) l'élément de recouvrement de toit de raccordement (a) est conçu avec une forme et des dimensions identiques à celles de l'élément de recouvrement de toit de base (b), mais avec la différence que, dans la surface libre de l'élément de recouvrement de toit de raccordement (a), un évidement de logement (a5) est réalisé pour le logement d'un agrégat de raccordement électrique (13) de l'élément solaire photovoltaïque (11), disposé sur la face inférieure de l'élément solaire photovoltaïque (11), et seule la surface libre de l'élément de recouvrement de toit de raccordement (a), qui s'étend à l'extérieur de l'évidement de logement (a5), est conçue comme une surface libre de l'élément de recouvrement de toit de raccordement (a) sur laquelle repose une portion correspondante de l'élément solaire photovoltaïque (11), la surface libre de l'élément de recouvrement de toit de raccordement (a), y compris l'évidement de logement (a5) est disposée de manière englobante, dans lequel le fond de l'élément de recouvrement de toit de raccordement (a), qui comprend l'évidement de logement (a5) pour l'agrégat de raccordement électrique (13) de l'élément solaire photovoltaïque (11) et de préférence également un dispositif de guidage de câble (a6) pour un câble de raccordement (14) de l'agrégat de raccordement électrique (13), ne présente, dans le recouvrement de toit, dans aucune portion de fond orientée vers l'infrastructure de toit (2), une ouverture qui permet le passage de l'eau et/ou de flammèches en direction de l'infrastructure de toit (2) et
dans lequel l'élément de recouvrement de toit de raccordement (a) et/ou l'élément de recouvrement de toit de base (b) comprend une feuillure d'eau de tête (a1, b1) et une feuillure d'eau de pied (a4, b4) et/ou une feuillure d'eau latérale (a2, b2) et une feuillure de recouvrement latérale (a3, b3) et
dans lequel
de l'évidement de logement (a5) réalisé dans l'élément de recouvrement de toit de raccordement (a), part un dispositif d'évacuation d'eau (a7),
v) dans lequel le dispositif d'évacuation d'eau (a7) dérive vers le pied de l'élément de recouvrement de toit de raccordement (a), à savoir vers la face supérieure de la feuillure de recouvrement de pied (a4) de l'élément de recouvrement de toit de raccordement (a) et/ou vers l'élément de recouvrement de toit (a, b w), disposé côté gouttière, du recouvrement de toit, de préférence dans la feuillure d'eau de tête (a1, b1) et/ou sur sa surface libre et/ou sur un élément solaire photovoltaïque (11) disposé sur sa surface libre,
et/ou
vv) dans lequel le dispositif d'évacuation d'eau (a7) dérive vers le bord latéral de l'élément de recouvrement de toit de raccordement (a), à savoir vers la feuillure d'eau latérale (a2) de l'élément de recouvrement de toit de raccordement (a) et/ou vers la feuillure de recouvrement latérale (a3) de l'élément de recouvrement de toit de raccordement (a) et de là vers un élément de recouvrement de toit (a, b w) du recouvrement de toit, disposé de manière adjacente latéralement dans le recouvrement de toit, de préférence dans sa feuillure d'eau latérale et/ou sur sa surface libre et/ou vers un élément photovoltaïque (11) disposé sur sa surface libre.

2. Recouvrement de toit selon la revendication 1,
**caractérisé en ce que**
dans l'élément de recouvrement de toit de raccordement (a), l'évidement de logement (a5)
- se raccorde au bord côté pied de la feuillure d'eau de tête (a1), de préférence l'évidement de logement (a5) et la feuillure d'eau de tête (a1) se succèdent de manière continue et/ou
- se raccorde à la feuillure d'eau latérale (a2), de préférence l'évidement de logement (a5) et la feuillure d'eau latérale (a2) se succèdent de manière continue.

3. Recouvrement de toit selon l'une des revendications précédentes,
**caractérisé en ce que**
le dispositif d'évacuation d'eau (a7) comprend un dispositif de guidage de l'eau formé de préférence dans le fond de l'élément de recouvrement de toit de raccorde (a), qui est conçu comme une évacuation d'eau (a7), par exemple sous la forme d'une rainure de guidage de l'eau, une goulotte de guidage de l'eau, un canal de guidage de l'eau.

4. Recouvrement de toit selon l'une des revendications précédentes,
**caractérisé en ce que**
une zone de transition est réalisée sous la forme d'un entonnoir entre l'évidement de logement (a5) et l'évacuation d'eau (a7).

5. Recouvrement de toit selon l'une des revendications précédentes,
**caractérisé en ce que**
l'évacuation d'eau (a7) présente une profondeur qui diminue de l'évidement de logement (a5) vers l'extrémité d'embouchure de l'évacuation d'eau (a7).

6. Recouvrement de toit selon l'une des revendications précédentes,
**caractérisé en ce que**
l'élément de recouvrement de toit de raccordement (a) et/ou l'élément solaire photovoltaïque (11) comprend un dispositif de guidage de câble (a6) dans lequel le câble de raccordement (14) de l'agrégat de raccordement électrique (13) du dispositif de raccordement électrique de l'élément solaire photovoltaïque (11) est disposé, au moins à certains portions.

7. Recouvrement de toit selon la revendication 6,
**caractérisé en ce que**
i) le dispositif de guidage de câble (a6) ou au moins une portion du dispositif de guidage de câble (a6) est disposé dans une enveloppe de l'élément solaire photovoltaïque (11) et/ou
ii) le dispositif de guidage de câble (a6) ou au moins une portion du dispositif de guidage de câble (a6) est disposé dans la feuillure d'eau de tête (a1) ou dans la feuillure d'eau latérale (a2) de l'élément de recouvrement de toit de raccordement (a) et/ou
iii) le dispositif de guidage de câble (a6) ou au moins une portion du dispositif de guidage de câble (a6) est disposé dans un bord externe côté tête ou côté pied ou latéral de l'élément de recouvrement de toit de raccordement (a), de préférence est disposé de façon à traverser et/ou à englober le bord et/ou
iv) le dispositif de guidage de câble (a6) ou au moins une portion du dispositif de guidage de câble (a6) est disposé sur la face supérieure du fond de l'élément de recouvrement de toit de raccordement (a) dans une zone du fond à l'extérieur de l'évidement de logement (a5) et/ou
v) le dispositif de guidage de câble (a6) ou au moins une portion du dispositif de guidage de câble (a6) est disposé dans le fond de l'évidement de logement (a5) et/ou dans la zone de bord supérieure de l'évidement de logement (a5).

8. Recouvrement de toit selon l'une des revendications 6 ou 7,
**caractérisé en ce que**
le dispositif de guidage de câble (a6) dans l'élément de recouvrement de toit de raccordement (a) est réalisé exclusivement sur la face supérieure, orientée vers le haut, de l'élément de recouvrement de toit de raccordement (a), sans que le câble de raccordement (14) qui y est disposé ne traverse une ouverture dans le fond de la face supérieure vers la face inférieure ou inversement de la face inférieure vers la face supérieure.

9. Recouvrement de toit selon l'une des revendications 6 à 8,
**caractérisé en ce que**
le guidage de câble (a6) dans l'élément de recouvrement de toit de raccordement (a) est réalisé sous la forme d'un renfoncement (a6), de préférence d'une rainure (a6), ouverte vers le haut, disposée côté fond ou côté bord, ou sous la forme d'un canal ou d'un perçage fermé vers le haut et/ou fermé sur toute la circonférence, disposé côté fond ou côté bord.

10. Recouvrement de toit selon l'une des revendications 6 à 9,
**caractérisé en ce que**
le dispositif de guidage de câble (a6) comprend un dispositif d'évacuation d'eau séparé correspondant ou **en ce que** le dispositif de guidage de câble (a6) est relié avec le dispositif d'évacuation d'eau (a7) de l'évidement de logement (a5), de préférence il est disposé à l'intérieur du dispositif d'évacuation d'eau (a7) de l'évidement de logement (a5).

11. Recouvrement de toit selon l'une des revendications précédentes,
**caractérisé en ce que**
dans l'élément de recouvrement de toit de raccordement (a), dans l'évidement de logement (a5) ou près de l'évidement de logement (a5), est réalisé un plateau d'appui (a10), conçu comme un bossage, qui présente une surface libre, qui est conçue comme une surface d'appui (a10), sur laquelle un élément de recouvrement de toit adjacent côté faîte ou deux éléments de recouvrement de toit adjacents côté faîte s'appuient avec leur bord côté pied.

12. Recouvrement de toit selon l'une des revendications précédentes,
**caractérisé en ce que**
l'élément solaire photovoltaïque (11) reposant sur la surface libre des éléments de recouvrement de toit (a, b) du module solaire (10) n'est pas disposé de façon à reposer sur la feuillure d'eau de tête (a1, b1) et/ou la feuillure d'eau latérale (a2,b2) des éléments de recouvrement de toit du module solaire (10) et n'englobe et/ou ne recouvre pas la feuillure d'eau de tête (a1, b1) et/ou la feuillure d'eau latérale (a2, b2).

13. Recouvrement de toit selon l'une des revendications précédentes,
**caractérisé en ce que**
l'élément solaire photovoltaïque (11), qui repose sur la surface libre composée des éléments de recouvrement de toit (a, b) du module solaire (10), est fixé sur les éléments de recouvrement de toit du module solaire (10) par l'intermédiaire d'une liaison mécanique par complémentarité de forme et/ou une liaison magnétique et/ou une liaison par collage.

14. Recouvrement de toit selon l'une des revendications précédentes,
**caractérisé en ce que**
les éléments de recouvrement de toit sont disposés, de préférence, dans le recouvrement de toit, qui comprend l'au moins un module solaire (10) ou à proximité duquel se trouve l'au moins un module solaire (10), de sorte que
a) les rangées horizontales d'éléments de recouvrement de toit adjacentes entre elles dans la direction du faîte / de la gouttière se superposent comme des écailles en formant des sortes d'écailles horizontales, de préférence le bord côté gouttière et/ou la portion de l'élément de recouvrement de toit disposée côté faîte englobe le bord côté faîte et/ou la portion de l'élément de recouvrement de toit disposée côté faîte ou
b) les rangées verticales d'éléments de recouvrement de toit adjacentes entre elles dans la direction latérale se superposent comme des écailles en formant des sortes d'écailles verticales, de préférence le bord côté gauche et/ou la portion de l'élément de recouvrement de toit disposée du côté droit englobe le bord côté droit et/ou la portion de l'élément de recouvrement de toit disposée du côté gauche.

15. Recouvrement de toit selon l'une des revendications précédentes,
**caractérisé en ce que**
l'élément de recouvrement de toit de base (b) du module solaire (10) est constitué d'un matériau de type céramique et/ou d'un matériau de type ciment et/ou d'un matériau métallique et/ou
l'élément de recouvrement de toit de raccordement (a) du module solaire (10) est constitué d'un matériau de type céramique et/ou d'un matériau de type ciment et/ou d'un matériau métallique et/ou d'un matériau de type matière plastique et/ou
les éléments de recouvrement de toit du reste du recouvrement de toit sont constitués d'un matériau de type céramique et/ou d'un matériau de type ciment et/ou d'un matériau métallique.
